(19) Europäisches Patentamt
European Patent Office
Office européen des brevets

(11) EP 2 842 744 A1

(12) **EUROPEAN PATENT APPLICATION**

(43) Date of publication:
**04.03.2015 Bulletin 2015/10**

(21) Application number: **14181755.1**

(22) Date of filing: **21.08.2014**

(51) Int Cl.:
***B41C 1/10*** (2006.01) ***G03F 7/032*** (2006.01)
***G03F 7/033*** (2006.01) ***G03F 7/035*** (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.08.2013 JP 2013180171**

(71) Applicant: **Fujifilm Corporation**
**Minato-ku**
**Tokyo 106-8620 (JP)**

(72) Inventor: **Hamada, Kazuhiro**
**Shizuoka (JP)**

(74) Representative: **Hoffmann Eitle**
**Patent- und Rechtsanwälte PartmbB**
**Arabellastraße 30**
**81925 München (DE)**

(54) **Resin composition for laser engraving, process for producing flexographic printing plate precursor for laser engraving, flexographic printing plate precursor for laser engraving, process for making flexographic printing plate, and flexographic printing plate**

(57) A resin composition for laser engraving that comprises (Component A) a resin that is a plastomer at 20°C, (Component B) a polymerizable compound, and (Component C) a polymerization initiator, wherein Component A has a constitutional repeating unit having an acid group, and the content of the constitutional repeating unit having an acid group is 0.01 to 15 mass% relative to a total mass of Component A.

A flexographic printing plate precursor that has a relief-forming layer formed of the resin composition for laser engraving on a support, and a flexographic printing plate precursor that has a crosslinked relief-forming layer obtained by crosslinking a relief-forming layer formed of the resin composition for laser engraving by heat and/or light.

EP 2 842 744 A1

## Description

The present invention relates to a resin composition for laser engraving, a process for producing a flexographic printing plate precursor for laser engraving, a flexographic printing plate precursor for laser engraving, a process for making a flexographic printing plate, and a flexographic printing plate.

A large number of so-called 'direct engraving CTP methods', in which a relief-forming layer is directly engraved by means of a laser are proposed. In the method, a laser light is directly irradiated to a flexographic printing plate precursor to cause thermal decomposition and volatilization in relief forming layer by photothermal conversion, thereby forming a concave part. Differing from a relief formation using an original image film, the direct engraving CTP method can control freely relief shapes. Consequently, when such image as an outline character is to be formed, it is also possible to engrave that region deeper than other regions, or, in the case of a fine halftone dot image, it is possible, taking into consideration resistance to printing pressure, to engrave while adding a shoulder. With regard to the laser for use in the method, a high-power carbon dioxide laser is generally used. In the case of the carbon dioxide laser, all organic compounds can absorb the irradiation energy and convert it into heat. On the other hand, inexpensive and small-sized semiconductor lasers have been developed, wherein, since they emit visible lights and near infrared lights, it is necessary to absorb the laser light and convert it into heat.

As a resin composition for laser engraving, those described in JP-A-2011-148299 (JP-A denotes a Japanese unexamined patent application publication) or JP-A-2005-47947 are known.

It is objects of the present invention to provide a resin composition for laser engraving that is excellent in rinsing properties for engraving residue generated at the time of laser engraving and can give a plate exhibiting excellent ink resistance with respect to various inks, to provide a flexographic printing plate precursor for laser engraving that uses the resin composition for laser engraving and a process for producing the precursor, and to provide a flexographic printing plate and a process for making the plate.

The above object of the present invention has been achieved by the means described in the following <1>, <8>, <9>, <11>, <13> or <16>. Preferable embodiments <2> to <7>, <10>, <12>, <14> and <15> will also be described below.

<1> A resin composition for laser engraving comprising (Component A) a resin that is a plastomer at 20°C, (Component B) a polymerizable compound, and (Component C) a polymerization initiator, wherein Component A has a constitutional repeating unit having an acid group, and the content of the constitutional repeating unit having an acid group is 0.01 to 15 mass% relative to a total mass of Component A.

<2> The resin composition for laser engraving as described in <1>, wherein Component A has a polymer chain selected from a group consisting of a polyurethane chain, a conjugated diene-based polymer chain, and a polysiloxane chain.

<3> The resin composition for laser engraving as described in <1 > or <2>, wherein Component A has an ethylenically unsaturated group.

<4> The resin composition for laser engraving as described in any one of <1> to <3>, wherein the acid group is a carboxyl group and/or an acid anhydride group.

<5> The resin composition for laser engraving as described in any one of <1> to <4>, wherein the acid group is a carboxyl group.

<6> The resin composition for laser engraving as described in any one of <1> to <5>, wherein the resin composition further comprises (Component D) a photothermal conversion agent.

<7> The resin composition for laser engraving as described in any one of <1> to <6>, wherein Component A has a (meth)acryloyl group.

<8> A flexographic printing plate precursor having a relief-forming layer formed of the resin composition for laser engraving as described in any one of <1> to <7> on a support.

<9> A flexographic printing plate precursor having a crosslinked relief-forming layer obtained by crosslinking a relief-forming layer formed of the resin composition for laser engraving as described in any one of <1> to <7> by heat and/or light.

<10> The flexographic printing plate precursor for laser engraving as described in <9>, wherein the crosslinking is performed by using heat.

<11> A process for producing a flexographic printing plate precursor for laser engraving, comprising steps of forming a relief-forming layer formed of the resin composition for laser engraving as described in any one of <1> to <7>, and crosslinking the relief-forming layer by heat and/or light to obtain a flexographic printing plate precursor having a crosslinked relief-forming layer.

<12> The process for producing a flexographic printing plate precursor for laser engraving as described in <11>, wherein in the step of crosslinking, crosslinking is performed by using heat.

<13> A process for making a flexographic printing plate, comprising a step of engraving the flexographic printing

plate precursor for laser engraving as described in < 9> or <10>, or the flexographic printing plate precursor for laser engraving obtained by the production process as described in <11> or <12> by using laser so as to form a relief layer.

<14> The process for making a flexographic printing plate as described in <13>, further comprising, after the step of engraving, a step of rinsing the surface of the relief layer with an aqueous rinsing liquid.

<15> The process for making a flexographic printing plate as described in <14>, wherein pH of the aqueous rinsing liquid is equal to or more than 10.

<16> A flexographic printing plate produced by the process for making a flexographic printing plate as described in any one of <13> to <15>.

In the present invention, the notation 'lower limit to upper limit', which expresses a numerical range, means 'at least the lower limit but no greater than the upper limit', and the notation 'upper limit to lower limit' means 'no greater than the upper limit but at least the lower limit'. That is, they are numerical ranges that include the upper limit and the lower limit. Furthermore, in the present invention, 'mass%' is used for the same meaning as 'weight%', and 'parts by mass' is used for the same meaning as 'parts by weight'.

In the present invention, '(meth)acrylate' means any one or both of 'acrylate' and 'methacrylate'.

Furthermore, '(Component A) a resin that is a plastomer at 20°C' etc. are also simply called 'Component A' etc.

In the present invention, a combination of preferred embodiments is more preferable embodiment.

(Resin composition for laser engraving)

The resin composition for laser engraving of the present invention (hereinafter, also simply referred to as a "resin composition") comprises (Component A) a resin that is a plastomer at 20°C, (Component B) a polymerizable compound, and (Component C) a polymerization initiator. In the resin composition, Component A has a constitutional repeating unit having an acid group, and the content of the constitutional repeating unit having an acid group is 0.01 to 15 mass% relative to a total mass of Component A.

In the present specification, when a flexographic printing plate precursor and a flexographic printing plate is explained, a layer that comprises Component A to Component C and serves as an image-forming layer subjected to laser engraving, that has a flat surface, and that is an uncrosslinked crosslinkable layer is called a relief-forming layer, a layer that is formed by crosslinking the relief-forming layer is called a crosslinked relief-forming layer, and a layer that has asperities formed on the surface by laser engraving the crosslinked relief-forming layer is called a relief layer.

Constituent components used in the resin composition for laser engraving of the present invention are explained below.

(Component A) Resin that is plastomer at 20°C

The resin composition for laser engraving of the present invention comprises (Component A) a resin that is a plastomer at 20°C. Component A has a constitutional repeating unit having an acid group, and the content of the constitutional repeating unit having an acid group is 0.01 to 15 mass% relative to a total mass of Component A.

The resin composition for laser engraving of the present invention contains Component A having an acid group in a specific amount. Accordingly, the resin composition is excellent in rinsing properties for engraving residue generated at the time of laser engraving and can give a plate exhibiting excellent ink resistance with respect to a solvent ink, a UV-curable ink (UV ink), and an aqueous ink.

The resin composition for laser engraving of the present invention comprises (Component A) a resin that is a plastomer at 20°C (hereinafter, the resin will be also simply referred to as a "plastomer").

In the present invention, the "plastomer" refers to a polymer which is easily fluidized and deformed by heating and can be solidified into a shape formed by deformation by cooling, as described in "Polymer Encyclopedia, New Edition" edited by The Society of Polymer Science, Japan (Japan, Asakura Publishing Co., Ltd., 1988). The "plastomer" is a contrasting term of an "elastomer" (a polymer having properties by which the polymer is deformed instantaneously by an external force when the external force is applied thereto and restores its original shape in a short time when the external force is removed). The plastomer does not undergo elastic deformation unlike the elastomer but easily undergoes plastic deformation.

In the present invention, the plastomer refers to a polymer having properties in which if the original size of the polymer is defined as 100%, the polymer can be deformed up to 200% by a small external force at room temperature (20°C), and even when the external force is removed, the polymer does not shrink to a size no greater than 130%. The "small external force" specifically refers to an external force that results in a tensile strength of 1 to 100 MPa. More specifically, the plastomer refers to a polymer having properties mentioned below. That is, when a tensile test is performed on the polymer at 20°C based on the tensile permanent set test of JIS K 6262-1997, the polymer can be stretched by

two times the gauge length of a dumbbell test specimen type 4 specified in JIS K 6251-1993, which has not been subjected to the tensile test, without being ruptured, and after the polymer is kept as is for 60 minutes from the point in time when it is stretched by 2 times the gauge length measured before the tensile test, a degree of tensile permanent set of the polymer becomes at least 30% after 5 minutes elapses from when the application of an external tensile strength is removed. In the present invention, the entire test process is based on the tensile permanent set test method of JIS K 6262-1997, except that the specimen is made into a dumbbell specified in JIS K 6251; the specimen is kept as is for 60 minutes; and the temperature of the test room is set to 20°C.

A polymer that cannot be measured by the aforementioned method, that is, a polymer which is deformed even if an external tensile strength is not applied thereto and does not restore its original shape in a tensile test or a polymer which is ruptured when the small external force used for the aforementioned measurement is applied thereto corresponds to the plastomer.

Furthermore, the resin as the plastomer of the present invention has a glass transition temperature (Tg) of a polymer of less than 20°C. In the case of a polymer having at least two kinds of Tg, all of the Tg is less than 20°C. The Tg of a polymer can be measured by differential scanning calorimetry (DSC).

Component A preferably has a polymer chain selected from a group consisting of a polyurethane chain, a conjugated diene-based polymer chain, and a polysiloxane chain, more preferably has a polymer chain selected from a group consisting of a conjugated diene-based polymer chain and a polysiloxane chain, yet more preferably at least has a polymer chain selected from a group consisting of a poly-conjugated diene chain, a hydrogenated poly-conjugated diene chain, and a polysiloxane chain, and particularly preferably has a poly-conjugated diene chain and/or a hydrogenated poly-conjugated diene chain. In this embodiment, rinsing properties for engraving residue and ink resistance with respect to various inks are further improved.

Moreover, Component A is preferably a resin having a urethane bond, more preferably a resin having a polymer chain, which is selected from a group consisting of a conjugated diene-based polymer chain, a hydrogenated poly-conjugated diene chain, and a polysiloxane chain, and a urethane bond, yet more preferably a resin having a polymer chain, which is selected from a group consisting of a hydrogenated poly-conjugated diene chain and a polysiloxane chain, and a urethane bond, and particularly preferably a resin having a hydrogenated poly-conjugated diene chain and a urethane chain. In this embodiment, rinsing properties for engraving residue and ink resistance with respect to various inks are further improved.

Examples of conjugated diene compounds in the conjugated diene-based polymer include butadiene, isoprene, chloroprene, and 2,3-dimethylbutadiene. Among these, butadiene and isoprene are preferable, and butadiene is particularly preferable.

The conjugated diene-based polymer is not particularly limited as long as it is a homopolymer or a copolymer of conjugated diene, and preferable examples thereof include polybutadiene, hydrogenated polybutadiene, polyisoprene, hydrogenated polyisoprene, and a butadiene-acrylonitrile copolymer. Among these, polybutadiene, hydrogenated polybutadiene, polyisoprene, and hydrogenated polyisoprene are more preferable.

As the polysiloxane chain, a linear polysiloxane chain is preferable, a polydialkylsiloxane chain is more preferable, and a polydimethylsiloxane chain is yet more preferable.

The acid group in Component A is preferably a group selected from a group consisting of a carboxyl group, an acid anhydride group, a sulfonic acid group, and a phosphoric acid group, more preferably a carboxyl group and/or an acid anhydride group, yet more preferably a carboxyl group and/or a carboxylic acid anhydride group, and particularly preferably a carboxyl group. In this embodiment, rinsing properties for engraving residue generated at the time of laser engraving are further improved, and ink resistance of the obtained plate with respect to various inks is further improved.

Moreover, the acid group in Component A is preferably a group selected from a group consisting of an aliphatic carboxyl group, an aliphatic acid anhydride group, an aliphatic sulfonic acid group, and an aliphatic phosphoric acid group.

In Component A, the content of the constitutional repeating unit having the acid group is 0.01 to 15 mass%, preferably 0.02 to 12 mass%, more preferably 0.05 to 10 mass%, yet more preferably 0.1 to 8 mass%, and particularly preferably 0.2 to 3 mass% relative to a total mass of Component A. In this embodiment, rinsing properties for engraving residue generated at the time of laser engraving are further improved, and ink resistance of the obtained plate with respect to various inks is further improved.

Moreover, from the viewpoint of rinsing properties of engraving residue at the time when a rinsing liquid with pH of less than 10 is used, in Component A, the content of the constitutional repeating unit having an acid group is preferably 8 to 15 mass% relative to a total mass of Component A.

Furthermore, Component A may have only one type of the constitutional repeating unit having an acid group or two or more kinds of the constitutional repeating units.

In addition, in the present invention, the constitutional repeating unit having an acid group may be either a monomer unit having an acid group or a unit which is formed when the monomer unit having an acid group is modified by a polymer reaction or the like. However, for example, when a molecule is added to the monomer unit for modification as in maleic anhydride modification, which will be described later, two constitutional repeating units, which include a

constitutional repeating unit derived from maleic anhydride and a constitutional repeating unit derived from the aforementioned monomer unit, are regarded as the constitutional repeating unit having an acid group.

The constitutional repeating unit having an acid group in Component A preferably contains constitutional repeating units represented by the following Formula (1) to Formula (3), more preferably contains a constitutional repeating unit represented by the following Formula (1) or Formula (2), yet more preferably contains a constitutional repeating unit represented by the following Formula (1), and particularly preferably is a constitutional repeating unit represented by the following Formula (1). In this embodiment, rinsing properties for engraving residue generated at the time of laser engraving are further improved, and ink resistance of the obtained plate with respect to various inks is further improved.

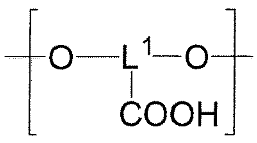

( 1 )

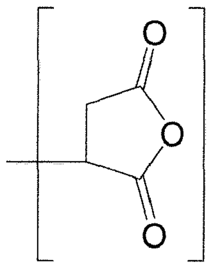

( 2 )

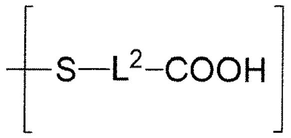

( 3 )

In Formula (1), $L^1$ denotes a trivalent linking group, and in Formula (3), $L^2$ denotes a divalent linking group.

The number of carbon atoms contained in the trivalent linking group denoted by $L^1$ is preferably 2 to 80, more preferably 2 to 40, and yet more preferably 2 to 20.

The trivalent linking group denoted by $L^1$ is preferably a trivalent hydrocarbon group, and more preferably a trivalent aliphatic hydrocarbon group.

The number of carbon atoms contained in the divalent linking group denoted by $L^2$ is preferably 2 to 80, more preferably 2 to 40, and yet more preferably 2 to 20.

The divalent linking group denoted by $L^2$ is preferably a divalent hydrocarbon group, and more preferably a divalent aliphatic hydrocarbon group.

The constitutional repeating unit represented by the Formula (1) is preferably a constitutional repeating unit represented by the following Formula (4), and particularly preferably a constitutional repeating unit represented by the following Formula (5). In this embodiment, rinsing properties for engraving residue generated at the time of laser engraving are further improved, and ink resistance of the obtained plate with respect to various inks is further improved.

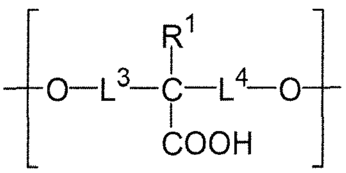

( 4 )

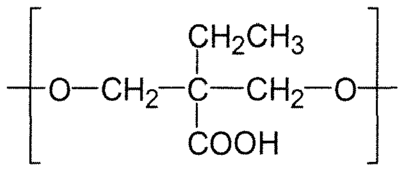

( 5 )

In Formula (4), each of $L^3$ and $L^4$ independently denotes a single bond or a divalent hydrocarbon group, and $R^1$ denotes a hydrogen atom or an alkyl group.

In each of the divalent hydrocarbon groups denoted by $L^3$ and $L^4$, the number of carbon atoms is preferably 1 to 20, more preferably 1 to 8, and yet more preferably 1 to 4.

Each of $L^3$ and $L^4$ is preferably a divalent aliphatic hydrocarbon group, more preferably a linear or branched alkylene group, yet more preferably a linear alkylene group, and particularly preferably a methylene group.

$R^1$ is preferably a hydrogen atom or an alkyl group having 1 to 10 carbon atoms, more preferably an alkyl group having 1 to 10 carbon atoms, and yet more preferably an ethyl group.

From the viewpoint of ink resistance and printing durability, it is preferable for Component A to contain an ethylenically unsaturated group.

Examples of the ethylenically unsaturated group in Component A include an ethylenically unsaturated group in a main chain derived from conjugated diene, an ethylenically unsaturated group on a terminal of the main chain, and the like.

It is preferable for Component A to at least have the ethylenically unsaturated group on the terminal thereof.

Moreover, from the viewpoint of ink resistance and printing durability, Component A preferably has a (meth)acryloyl group and more preferably has a (meth)acryloyl group on the terminal thereof.

Furthermore, Component A is preferably a polyurethane resin having a polymer chain, which is selected from a group consisting of a conjugated diene-based polymer chain, a hydrogenated poly-conjugated diene chain, and a polysiloxane chain, and having the constitutional repeating unit represented by Formula (1), more preferably a polyurethane resin having a polymer chain, which is selected from a group consisting of a hydrogenated poly-conjugated diene chain and a polysiloxane chain, and having the constitutional repeating unit represented by Formula (1), yet more preferably a polyurethane resin having a polymer chain, which is selected from a group consisting of a hydrogenated poly-conjugated diene chain and a polysiloxane chain, in a portion of the main chain thereof and having the constitutional repeating unit represented by Formula (1), and particularly preferably a polyurethane resin having an ethylenically unsaturated group on the terminal of the main chain thereof, having a polymer chain, which is selected from a group consisting of a hydrogenated poly-conjugated diene chain and a polysiloxane chain, in a portion of the main chain thereof, and having the constitutional repeating unit represented by Formula (1).

Component A is preferably a linear resin, more preferably a linear polyurethane resin, yet more preferably a linear polyurethane resin obtained by polycondensation by using at least a diol compound and a diisocyanate compound, and particularly preferably a linear polyurethane resin obtained by polycondensation by using at least a diol compound, which is selected from a group consisting of poly-conjugated diene diol, hydrogenated poly-conjugated diene diol, and polysiloxane diol, a diol compound having an acid group, and a diisocyanate compound.

The process for producing Component A is not particularly limited, and known methods can be used. Specifically, examples of the methods include a method of causing a polyfunctional alcohol compound having an acid group to react with a polyfunctional isocyanate compound, and a method of causing an ene reaction, a radical reaction, or an addition reaction in the presence of water between a resin having an ethylenically unsaturated bond and maleic anhydride.

Moreover, for the aforementioned reaction, known reaction conditions, additives, and the like can be used. For example, for causing an ene reaction, a stabilizer such as an antioxidant or a catalyst may be used, and for causing a radical reaction, it is preferable to use a radical polymerization initiator.

Among the methods, a method of obtaining Component A by causing a reaction between a poly-conjugated diene diol or a hydrogenated poly-conjugated diene diol, a polyfunctional alcohol compound having an acid group, and a polyfunctional isocyanate compound, or a method of obtaining Component A by causing a reaction between the poly-conjugated diene and maleic anhydride is preferably exemplified.

For example, when an ene reaction is caused between polybutadiene and maleic anhydride, in many cases, the resin contains at least one of the constitutional units shown below. Moreover, needless to say, the position of an ethylenically unsaturated bond in the following constitutional unit may be moved in some cases by isomerization.

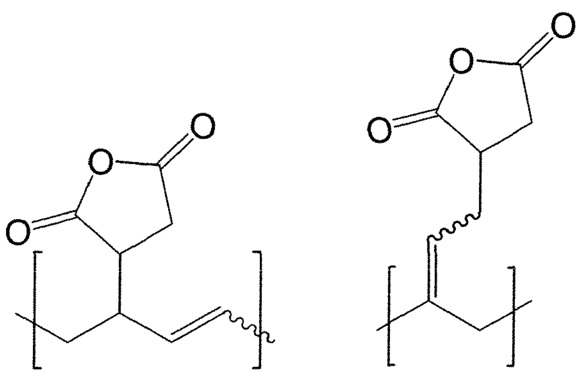

The molecular weight of Component A is preferably 1,000 to 1,000,000, more preferably 1,500 to 200,000, and yet more preferably 2,000 to 100,000, in terms of a number average molecular weight (GPC, expressed in terms of polystyrene). When the molecular weight is within the above range, the resin composition for laser engraving comprising Component A is easily processed, and a flexographic printing plate precursor and a flexographic printing plate having excellent strength can be obtained.

In the present invention, it is preferable to measure the weight average molecular weight or number average molecular weight by gel permeation chromatography (GPC). In the present invention, for the measurement performed by gel permeation chromatography, it is preferable to use HLC-8020GPC (manufactured by TOSOH CORPORATION), TSKgel Super HZ M-H, TSKgel Super HZ4000, and TSKgel Super HZ200 (manufactured by TOSOH CORPORATION, 4.6 mm ID x 15 cm) as columns, and tetrahydrofuran (THF) as an eluent.

In the present invention, with regard to Component A, one type thereof may be used on its own, or two or more

types thereof may be used concurrently.

In the resin composition for laser engraving of the present invention, the content of Component A is preferably 5 to 90 mass%, more preferably 15 to 85 mass%, yet more preferably 30 to 80 mass%, particularly preferably 50 to 80 mass%, and most preferably 60 to 80 mass% in a total solid mass content. Here, the "solid mass content" refers to components in the resin composition for laser engraving excluding volatile components such as a solvent.

When the content of Component A is within the above range, a film which exhibits strong resistance to various inks and has a high degree of toughness and flexibility is obtained.

(Component B) Polymerizable compound

In order to promote formation of a crosslinked structure, the resin composition for laser engraving of the present invention comprises (Component B) a polymerizable compound. If the resin composition comprises Component B, a crosslinked relief forming layer and relief layer having higher breaking strength are obtained.

Component B is a polymerizable compound other than Component A.

Component B is preferably a radically polymerizable compound. In addition, Component B is preferably an ethylenically unsaturated compound.

Component B preferably comprises a polyfunctional ethylenically unsaturated compound, and may comprise a monofunctional ethylenically unsaturated compound with the polyfunctional ethylenically unsaturated compound, and is preferably a polyfunctionalethylenically unsaturated compound.

Component B is preferably a compound having a molecular weight of less than 1,000 from the viewpoint of miscibility of Component A and Component B.

The resin composition for laser engraving of the present invention preferably comprises as Component B a polyfunctional ethylenically unsaturated compound. When in this mode, a crosslinked relief forming layer and relief layer having higher breaking strength are obtained.

The polyfunctional ethylenically unsaturated compound is preferably a compound having 2 to 20 terminal ethylenically unsaturated groups. A group of such compounds is widely known in the present industrial field, and in the present invention these compounds may be used without particular limitations. Examples of these compounds include those having a chemical form such as a monomer, a prepolymer, i.e. a dimer, a trimer, and an oligomer, and a mixture thereof, and a copolymer thereof.

Examples of a compound from which the ethylenically unsaturated group in the polyfunctional ethylenically unsaturated compound is derived include an unsaturated carboxylic acid (e.g. acrylic acid, methacrylic acid, itaconic acid, crotonic acid, isocrotonic acid, maleic acid, etc.), and an ester or amide thereof. An ester between an unsaturated carboxylic acid and an aliphatic polyhydric alcohol compound and an amide between an unsaturated carboxylic acid and an aliphatic polyvalent amine compound are preferably used. Furthermore, an addition reaction product of an unsaturated carboxylic acid ester or amide having a nucleophilic substituent such as a hydroxy group or an amino group, and a polyfunctional isocyanate or an epoxide, and a dehydration-condensation reaction product with a polyfunctional carboxylic acid, are also suitably used. Furthermore, an addition reaction product between a monofunctional or polyfunctional alcohol or amine and an unsaturated carboxylic acid ester or amide having an electrophilic substituent such as an isocyanate group or an epoxy group, and a substitution reaction product between a monofunctional or polyfunctional alcohol or amine and an unsaturated carboxylic acid ester or amide having a leaving substituent such as a halogen group or a tosyloxy group are also suitable. As another example, a group of compounds formed by replacing the unsaturated carboxylic acid with a vinyl compound, an allyl compound, an unsaturated phosphonic acid, or styrene may also be used.

The ethylenically unsaturated group contained in the polyfunctional ethylenically unsaturated compound is preferably an acrylate, methacrylate, vinyl compound, or allyl compound residue from the viewpoint of reactivity. Furthermore, from the viewpoint of printing durability, the polyfunctional ethylenically unsaturated compound preferably comprises at least two ethylenically unsaturated groups, and more preferably comprises two ethylenically unsaturated groups.

Specific examples of ester monomers comprising an ester of a polyhydric alcohol compound and an unsaturated carboxylic acid include acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and a polyester acrylate oligomer.

Examples of methacrylic acid esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[*p*-(3-methacryloxy-2-hydroxypropoxy)phenyl]dimethylmethane, and bis[p-(methacryloxyethoxy)phenyl]dimethylmethane.

Examples of itaconic acid esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of crotonic acid esters include ethylene glycol dicrotonate, tetramethylene glycol dicrotonate, pentaerythritol dicrotonate, and sorbitol tetracrotonate.

Examples of isocrotonic acid esters include ethylene glycol diisocrotonate, pentaerythritol diisocrotonate, and sorbitol tetraisocrotonate.

Examples of maleic acid esters include ethylene glycol dimaleate, triethylene glycol dimaleate, pentaerythritol dimaleate, and sorbitol tetramaleate.

As examples of other esters, aliphatic alcohol-based esters described in JP-B-46-27926 (JP-B denotes a Japanese examined patent application publication), JP-B-51-47334 and JP-A-57-196231, those having an aromatic skeleton described in JP-A-59-5240, JP-A-59-5241, and JP-A-2-226149, those having an amino group described in JP-A-1-165613, etc. may also be used preferably.

The above-mentioned ester monomers may be used as a mixture of two or more types.

Furthermore, specific examples of amide monomers of an amide of an aliphatic polyamine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide, and xylylenebismethacrylamide.

Preferred examples of other amide-based monomers include those having a cyclohexylene structure described in JP-B-54-21726.

Furthermore, a urethane-based addition-polymerizable compound produced by an addition reaction of an isocyanate and a hydroxy group is also suitable, and specific examples thereof include a vinylurethane compound comprising two or more polymerizable vinyl groups per molecule in which a hydroxy group-containing vinyl monomer represented by Formula (i) below is added to a polyisocyanate compound having two or more isocyanate groups per molecule described in JP-B-48-41708.

$$CH_2{=}C(R)COOCH_2CH(R)OH \qquad (i)$$

wherein R and R' independently denote H or $CH_3$.

Furthermore, urethane acrylates described in JP-A-51-37193, JP-B-2-32293, and JP-B-2-16765, and urethane compounds having an ethylene oxide-based skeleton described in JP-B-58-49860, JP-B-56-17654, JP-B-62-39417, JP-B-62-39418 are also suitable.

Furthermore, the curable composition having excellent short time curability can be obtained by use of an addition-polymerizable compound having an amino structure in the molecule described in JP-A-63-277653, JP-A-63-260909, and JP-A-1-105238.

Other examples include polyester acrylates such as those described in JP-A-48-64183, JP-B-49-43191, and JP-B-52-30490, and polyfunctional acrylates and methacrylates such as epoxy acrylates formed by a reaction of an epoxy resin and (meth)acrylic acid. Examples also include specific unsaturated compounds described in JP-B-46-43946, JP-B-1-40337, and JP-B-1-40336, and vinylphosphonic acid-based compounds described in JP-A-2-25493. In some cases, perfluoroalkyl group-containing structures described in JP-A-61-22048 are suitably used. Moreover, those described as photocuring monomers or oligomers in the Journal of the Adhesion Society of Japan, Vol. 20, No. 7, pp. 300 to 308 (1984) may also be used.

Examples of the vinyl compounds include butanediol-1,4-divinyl ether, ethylene glycol divinyl ether, 1,2-propanediol divinyl ether, 1,3-propanediol divinyl ether, 1,3-butanediol divinyl ether, 1,4-butanediol divinyl ether, neopentyl glycol divinyl ether, trimethylolpropane tirvinyl ether, trimethylolethane trivinyl ether, hexanediol divinyl ether, tetraethylene glycol divinyl ether, pentaerythritol divinyl ether, pentaerythritol trivinyl ether, pentaerythritol tetravinyl ether, sorbitol tetravinyl ether, sorbitol pentavinyl ether, ethylene glycol diethylenevinyl ether, ethylene glycol dipropylenevinyl ether, trimethylolpropane triethylenevinyl ether, trimethylolpropane diethylenevinyl ether, pentaerythritol diethylenevinyl ether, pentaerythritol triethylenevinyl ether, pentaerythritol tetraethylenevinyl ether, 1,1,1-tris[4-(2-vinyloxyethoxy)phenyl] ethane, bisphenol A divinyloxyethyl ether, divinyl adipate, etc.

Examples of the allyl compounds include polyethylene glycol diallyl ether, 1,4-cyclohexane diallyl ether, 1,4-diethylcyclohexyl diallyl ether, 1,8-octane diallyl ether, trimethylolpropane diallyl ether, trimethylolethane triallyl ether, pentaerythritol triallyl ether, pentaerythritol tetraallyl ether, dipentaerythritol pentaallyl ether, dipentaerythritol hexaallyl ether, diallyl phthalate, diallyl terephthalate, diallyl isophthalate, triallyl isocyanurate, triallyl cyanurate, triallyl phosphate, etc.

Particularly, from the viewpoint of compatibility and crosslinkability between Component A and Component B, as for Component B, (meth)acrylate compounds are more preferable.

Among them, preferred examples of Component B include diethylene glycol di(meth)acrylate, triethylene glycol di(meth)acrylate, dipentaerythritol hexa(meth)acrylate, tricyclodecanedimethanol di(meth)acrylate, trimethylolpropane tri(meth)acrylate, pentaerythritol tetra(meth)acrylate, and 1,6-hexanediol di(meth)acrylate, and more preferred examples of Component B include triethylene glycol di(meth)acrylate and 1,6-hexanediol di(meth)acrylate.

The resin composition for laser engraving of the present invention may comprise a monofunctional ethylenically unsaturated compound, but if the resin composition comprises a monofunctional ethylenically unsaturated compound, it is preferable that the resin composition comprise a monofunctional ethylenically unsaturated compound in combination with a polyfunctional ethylenically unsaturated compound.

Examples of the monofunctional ethylenically unsaturated compound having one ethylenically unsaturated bond in the molecule include esters of unsaturated carboxylic acids (for example, acrylic acid, methacrylic acid, itaconic acid, crotonic acid, isocrotonic acid, and maleic acid) and monohydric alcohol compounds, and amides of unsaturated carboxylic acids and monovalent amine compounds.

Furthermore, addition reaction products of an unsaturated carboxylic acid ester or amide having a nucleophilic substituent such as a hydroxyl group, an amino group or a mercapto group, and an isocyanate or an epoxide, and dehydration condensation reaction products with a monofunctional or polyfunctional carboxylic acid, are also suitably used.

Furthermore, addition reaction products of an unsaturated carboxylic acid ester or amide having an electrophilic substituent such as an isocyanato group or an epoxy group, and an alcohol, an amine or a thiol, and substitution reaction products of an unsaturated carboxylic acid ester or amide having a detachable substituent such as a halogeno group or a tosyloxy group, and an alcohol, an amine or a thiol, are also suitable.

Also, as other examples, a group of compounds substituted with unsaturated phosphonic acid, styrene, vinyl ether or the like instead of the unsaturated carboxylic acid described above, can also be used.

The polymerizable compound is not particularly limited, and various known compounds can be used in addition to the compounds exemplified above. For example, those compounds described in JP-A-2009-204962 and the like may also be used.

With regard to Component B in the resin composition for laser engraving of the present invention, only one type may be used on its own or two or more types may be used in combination.

From the viewpoint of flexibility and strength of the cross-linked film, the content of Component B in the resin composition for laser engraving of the present invention is preferably 0.1 to 40 mass %, more preferably 1 to 40 mass %, yet more preferably 2 to 30 mass %, and particularly preferably 5 to 20 mass %, relative to the total mass of the resin composition.

(Component C) Polymerization initiator

In order to promote formation of a crosslinked structure, the resin composition for laser engraving of the present invention comprises (Component C) a polymerization initiator.

With regard to the polymerization initiator, one known to a person skilled in the art may be used without any limitations. A radical polymerization initiator, which is a preferred polymerization initiator, is explained in detail below, but the present invention should not be construed as being limited by these descriptions.

Component C is preferably a radical polymerization initiator, and preferred examples thereof include compounds described in paragraphs 0074 to 0118 of JP-A-2008-63554

The radical polymerization initiators includes aromatic ketones, onium salt compounds, organic peroxides, thio compounds, hexaallylbiimidazole compounds, ketoxime ester compounds, borate compounds, azinium compounds, metallocene compounds, active ester compounds, compounds having a carbon halogen bond, and azo compounds. When applies to the relief-forming layer of the flexographic printing plate precursor, from the viewpoint of engraving sensitivity and making a favorable relief edge shape, organic peroxides and azo compounds are preferably, and organic peroxides are particularly preferable.

The organic peroxide is preferably a compound described in JP-A-2008-63554 or JP-A-2008-233244, and more preferably *t*-butylperoxybenzoate.

From the viewpoint of engraving sensitivity, combined use of an organic peroxide and a photothermal conversion agent in combination is more preferable, and combined use of an organic peroxide and carbon black, that is a photothermal conversion agent in combination is particularly preferable.

This is presumed as follows. When the relief-forming layer is cured by thermal crosslinking using an organic peroxide, an organic peroxide that did not play a part in radical generation and has not reacted remains, and the remaining organic peroxide works as an autoreactive additive and decomposes exothermally in laser engraving. As the result, energy of generated heat is added to the irradiated laser energy to thus raise the engraving sensitivity.

It will be described in detail in the explanation of photothermal converting agent, the effect thereof is remarkable when carbon black is used as the photothermal converting agent. It is considered that the heat generated from the carbon black is also transmitted to an organic peroxide and, as the result, heat is generated not only from the carbon black but also from the organic peroxide, and that the generation of heat energy to be used for the decomposition of Component B etc. occurs synergistically.

With regard to the polymerization initiator in the resin composition of the present invention, only one type thereof may be used or two or more types thereof may be used in combination.

The content of the polymerization initiator in the resin composition for laser engraving of the present invention is preferably 0.1 to 10 mass %, and more preferably 0.1 to 3 mass %, relative to the total solid mass of the resin composition.

The resin composition for laser engraving of the present invention contains Component A to Component C as essential components and may contain other components. Examples of other components include (Component D) a photothermal conversion agent, (Component E) a compound having a hydrolysable silyl group and/or silanol group, (Component F) a solvent, (Component G) a fragrance, (Component H) a filler, (Component I) a binder polymer other than Component A, and the like, but the other components are not limited to these.

(Component D) Photothermal conversion

The resin composition for laser engraving of the present invention preferably comprises (Component D) a photothermal conversion agent.

That is, it is considered that the photothermal conversion agent in the present invention can promote the thermal decomposition of a cured material during laser engraving by absorbing laser light and generating heat. Therefore, it is preferable that a photothermal conversion agent capable of absorbing light having a wavelength of laser used for engraving be selected.

When a laser (a YAG laser, a semiconductor laser, a fiber laser, a surface emitting laser, etc.) emitting infrared at a wavelength of 700 to 1,300 nm is used as a light source for laser engraving, it is preferable for the relief printing plate precursor for laser engraving which is produced by using the resin composition for laser engraving of the present invention to comprise a photothermal conversion agent that has a maximun absorption wavelength at 700 to 1,300 nm. As the photothermal conversion agent in the present invention, various types of dye or pigment are used.

With regard to the photothermal conversion agent, examples of dyes that can be used include commercial dyes and known dyes described in publications such as 'Senryo Binran' (Dye Handbook) (Ed. by The Society of Synthetic Organic Chemistry, Japan, 1970). Specific preferable examples include dyes having a maximum absorption wavelength from 700 nm to 1,300 nm, and such preferable examples include azo dyes, metal complex salt azo dyes, pyrazolone azo dyes, naphthoquinone dyes, anthraquinone dyes, phthalocyanine dyes, carbonium dyes, diimmonium compounds, quinone imine dyes, methine dyes, cyanine dyes, squarylium colorants, pyrylium salts, and metal thiolate complexes. In particular, cyanine-based colorants such as heptamethine cyanine colorants, oxonol-based colorants such as pentamethine oxonol colorants, and phthalocyanine-based colorants are preferably used. Examples include dyes described in paragraphs 0124 to 0137 of JP-A-2008-63554.

With regard to the photothermal conversion agent used in the present invention, examples of pigments include commercial pigments and pigments described in the Color Index (C.I.) Handbook, 'Saishin Ganryo Binran' (Latest Pigments Handbook) (Ed. by Nippon Ganryo Gijutsu Kyokai, 1977), 'Saisin Ganryo Ouyogijutsu' (Latest Applications of Pigment Technology) (CMC Publishing, 1986), 'Insatsu Inki Gijutsu' (Printing Ink Technology) CMC Publishing, 1984). Examples of a pigment include a pigment described in paragraphs 0122 to 0125 of JP-A-2009-178869.

Among these pigments, carbon black is preferable. Any carbon black, regardless of classification by ASTM and application (e.g. for coloring, for rubber, for dry cell, etc.), may be used as long as dispersibility, etc. in the composition is stable. Carbon black includes for example furnace black, thermal black, channel black, lamp black, and acetylene black. In order to make dispersion easy, a black colorant such as carbon black may be used as color chips or a color paste by dispersing it in nitrocellulose or a binder in advance using, as necessary, a dispersant, and such chips and paste are readily available as commercial products. Examples of carbon black include carbon black described in paragraphs 0130 to 0134 of JP-A-2009-178869.

The photothermal conversion agent in the resin composition of the present invention may be used singly or in a combination of two or more compounds.

The content of the photothermal conversion agent in the resin composition for laser engraving of the present invention may vary greatly with the magnitude of the molecular extinction coefficient inherent to the molecule, but the content is preferably 0.01 to 30 mass%, more preferably 0.05 to 20 mass %, and particularly preferably 0.1 to 10 mass%, relative to the total solid mass of the resin composition.

(Component E) Compound comprising at least one type from a hydrolyzable silyl group and a silanol group

The resin composition for laser engraving of the present invention may comprise (Component E) a compound comprising at least one type from a hydrolyzable silyl group and a silanol group (hereinafter, called as appropriate a 'Component E'), and preferably does not comprise Component E.

The 'hydrolyzable silyl group' means a silyl group having hydrolyzability, examples of the hydrolyzable group include an alkoxy group, a mercapto group, a halogen atom, an amide group, an acetoxy group, an amino group, and an isopropenoxy group. A silyl group undergoes hydrolysis to become a silanol group, and a resulting silanol group undergoes dehydration-condensation to form a siloxane bond. Such a hydrolyzable silyl group and/or silanol group is preferably represented by Formula (E-1).

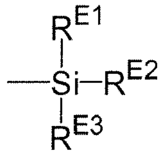

(E-1)

In Formula (E-1) above, at least one of $R^{E1}$ to $R^{E3}$ denotes a hydrolyzable group selected from the group consisting of an alkoxy group, a mercapto group, a halogen atom, an amide group, an acetoxy group, an amino group, and an isopropenoxy group, or a hydroxy group. The remainder of $R^{E1}$ to $R^{E3}$ independently denotes a hydrogen atom, a halogen atom, or a monovalent organic substituent (examples including an alkyl group, an aryl group, an alkenyl group, an alkynyl group, and an aralkyl group).

In Formula (E-1) above, the hydrolyzable group bonded to the silicon atom is particularly preferably an alkoxy group or a halogen atom, and more preferably an alkoxy group.

From the viewpoint of rinsing properties and printing durability, the alkoxy group is preferably an alkoxy group having 1 to 30 carbon atoms, more preferably an alkoxy group having 1 to 15 carbon atoms, yet more preferably having 1 to 5 carbon atoms, particularly preferably an alkoxy group having 1 to 3 carbon atoms, and most preferably a methoxy group or an ethoxy group.

Furthermore, examples of the halogen atom include an F atom, a Cl atom, a Br atom, and an I atom, and from the viewpoint of ease of synthesis and stability it is preferably a Cl atom or a Br atom, and more preferably a Cl atom.

Component E in the present invention is preferably a compound having one or more groups represented by Formula (E-1) above, and more preferably a compound having two or more. A compound having two or more hydrolyzable silyl groups is particularly preferably used. That is, a compound having in the molecule two or more silicon atoms having a hydrolyzable group bonded thereto is preferably used. The number of silicon atoms having a hydrolyzable group bond thereto is preferably at least 2 but no greater than 6, and most preferably 2 or 3.

A range of 1 to 4 of the hydrolyzable groups may bond to one silicon atom, and the total number of hydrolyzable groups in Formula (E-1) is preferably in a range of 2 or 3. It is particularly preferable that three hydrolyzable groups are bonded to a silicon atom. When two or more hydrolyzable groups are bonded to a silicon atom, they may be identical to or different from each other.

Specific preferred examples of the alkoxy group include a methoxy group, an ethoxy group, a propoxy group, an isopropoxy group, a butoxy group, a tert-butoxy group, a phenoxy group, and a benzyloxy group. A plurality of each of these alkoxy groups may be used in combination, or a plurality of different alkoxy groups may be used in combination.

Examples of the alkoxysilyl group having an alkoxy group bonded thereto include a trialkoxysilyl group such as a trimethoxysilyl group, a triethoxysilyl group, a triisopropoxysilyl group, or a triphenoxysilyl group; a dialkoxymonoalkylsilyl group such as a dimethoxymethylsilyl group or a diethoxymethylsilyl group; and a monoalkoxydialkylsilyl group such as a methoxydimethylsilyl group or an ethoxydimethylsilyl group.

Component E preferably has at least a sulfur atom, an ester bond, a urethane bond, an ether bond, a urea bond, or an imino group.

Among them, from the viewpoint of crosslinkability, Component E preferably comprises a sulfur atom, and from the viewpoint of removability (rinsing properties) of engraving residue it is preferable for it to comprise an ester bond, a urethane bond, or an ether bond (in particular, an ether bond contained in an oxyalkylene group), which is easily decomposed by aqueous alkali. Component E containing a sulfur atom functions as a vulcanizing agent or a vulcanization accelerator when carrying out a vulcanization treatment, thus promoting a reaction (crosslinking) of Component A. As a result, the rubber elasticity necessary as a printing plate is exhibited. Furthermore, the strength of a crosslinked relief-forming layer and a relief layer is improved.

Furthermore, Component E is preferably the compound that does not comprise an ethylenically unsaturated group.

As Component E in the present invention, there can be cited a compound in which a plurality of groups represented by Formula (E-1) above are bonded via a divalent linking group, and from the viewpoint of the effect, such a divalent linking group is preferably a linking group having a sulfide group (-S-), an imino group (-N(R)-) a urea group or a urethane bond (-OCON(R)- or -N(R)COO-). R denotes a hydrogen atom or a substituent. Examples of the substituent denoted by R include an alkyl group, an aryl group, an alkenyl group, an alkynyl group, and an aralkyl group.

Specific examples of Component E include a compound described in paragraphs 0024 to 0033 of JP-A-2011-148299.

Component E may be obtained by synthesis as appropriate, but use of a commercially available product is preferable in terms of cost. Since Component E corresponds to for example commercially available silane products or silane coupling agents from Shin-Etsu Chemical Co., Ltd., Dow Corning Toray, Momentive Performance Materials Inc., Chisso Corporation, etc., the resin composition of the present invention may employ such a commercially available product by appropriate selection according to the intended application.

As Component E, a partial hydrolysis-condensation product obtained using one type of compound having a hydrolyzable silyl group and/or a silanol group or a partial cohydrolysis-condensation product obtained using two or more types may be used. Hereinafter, these compounds may be called 'partial (co)hydrolysis-condensation products'.

Among silane compounds as partial (co)hydrolysis-condensation product precursors, from the viewpoint of versatility, cost, and film compatibility, a silane compound having a substituent selected from a methyl group and a phenyl group as a substituent on the silicon is preferable. Specific preferred examples of the precursor include methyltrimethoxysilane, methyltriethoxysilane, phenyltrimethoxysilane, phenyltriethoxysilane, dimethyldimethoxysilane, dimethyldiethoxysilane, diphenyldimethoxysilane, and diphenyldiethoxysilane.

In this case, as a partial (co)hydrolysis-condensation product, it is preferable to use a dimer (2 moles of silane compound is reacted with 1 mole of water to eliminate 2 moles of alcohol, thus giving a disiloxane unit) of the silane compounds cited above to 100-mer of the above-mentioned silane compound, more preferably a dimer to 50-mer, and yet more preferably a dimer to 30-mer, and it is also possible to use a partial (co)hydrolysis-condensation product formed using two or more types of silane compounds as starting materials.

As such a partial (co)hydrolysis-condensation product, ones commercially available as silicone alkoxy oligomers may be used (e.g. those from Shin-Etsu Chemical Co., Ltd.) or ones that are produced in accordance with a standard method by reacting a hydrolyzable silane compound with less than an equivalent of hydrolytic water and then removing by-products such as alcohol and hydrochloric acid may be used. When the production employs, for example, an acyloxysilane or an alkoxysilane described above as a hydrolyzable silane compound starting material, which is a precursor, partial hydrolysis-condensation may be carried out using as a reaction catalyst an acid such as hydrochloric acid or sulfuric acid, an alkali metal or alkaline earth metal hydroxide such as sodium hydroxide or potassium hydroxide, or an alkaline organic material such as triethylamine, and when the production is carried out directly from a chlorosilane, water and alcohol may be reacted using hydrochloric acid by-product as a catalyst.

With regard to Component E in the resin composition for laser engraving, one type thereof may be used on its own or two or more types may be used in combination.

The content of Component E in the resin composition for laser engraving is preferably in the range of 0.1 to 50 mass% relative to the total solid mass of the resin composition, more preferably in the range of 0.5 to 20 mass%, and yet more preferably in the range of 1 to 10 mass%.

(Component F) Solvent

The resin composition for laser engraving of the present invention may comprise (Component F) a solvent.

From the viewpoint of dissolving each of the components, a solvent is preferably mainly an aprotic organic solvent. More specifically, solvents are used preferably at aprotic organic solvent/protic organic solvent = 100/0 to 50/50 (ratio by mass), more preferably 100/0 to 70/30, and particularly preferably 100/0 to 90/10.

Specific preferred examples of the aprotic organic solvent include hexane, heptane, octane, nonane, cyclohexane, cyclohexannone, acetonitrile, tetrahydrofuran, dioxane, toluene, propylene glycol monomethyl ether acetate (PGMEA), methyl ethyl ketone, acetone, methyl isobutyl ketone, ethyl acetate, butyl acetate, ethyl lactate, N,N-dimethylacetamide, N-methylpyrrolidone, and dimethyl sulfoxide.

Specific preferred examples of the protic organic solvent include methanol, ethanol, 1-propanol, 2-propanol, 1-butanol, 1-methoxy-2-propanol, ethylene glycol, diethylene glycol, and 1,3-propanediol.

Among them, propylene glycol monomethyl ether acetate is preferable.

The content of the solvents is not particularly limited, and solvents necessary for forming a relief-forming layer. may be added. Meanwhile, the solid mass content of the resin composition means the content except for the solvents in the resin composition.

(Component G) Fragrance

The resin composition for laser engraving of the present invention comprises preferably a fragrance. The fragrance is effective for reducing odor generated in producing a relief printing plate precursor or in laser engraving.
As the fragrance, known fragrances can be appropriately selected and used. With regard to the fragrance, one type thereof can be used on its own, or plural types thereof can be used in combination.
It is preferable to appropriately select the fragrance according to the components used for the resin composition, and it is preferable for combining known fragrances to optimize the effect. Examples of the fragrances include those described in "Synthetic Fragrances-Chemistry and Knowledge of Products" (Motoichi Indo, published by The Chemical Daily Co., Ltd.), "Introduction to Fragrance Chemistry" (Shoji Watanabe, published by BAIFUKAN CO., LTD.), "Encyclopedia of Fragrance" (edited by Japan Perfumery & Flavoring Association, published by Asakura Publishing Co., Ltd.), and "Fragrance Chemistry Guide II, Isolated Fragrance-Synthetic Fragrance-Application of Fragrance" (published by Hirokawa Shoten Ltd.).
Moreover, examples of fragrances usable in the present invention include the fragrances described in paragraphs 0012 to 0025 of JP-A-2009-203310 and the fragrances described in paragraphs 0081 to 0089 of JP-A-2011-245818.
The content of the fragrance is preferably 0.003 to 1.5 mass% and more preferably 0.005 to 1.0 mass% in a total solid mass content of the resin composition for laser engraving. If the content is within this range, a masking effect can be sufficiently exhibited, scent of the fragrance is controlled to an appropriate degree, working environment is improved, and engraving sensitivity becomes excellent.

(Component H) Filler

The resin composition for laser engraving of the present invention may comprise (Component H) a filler in order to improve the physical properties of a cured film of the resin composition for laser engraving.
As the filler, a known filler may be used, and examples thereof include inorganic particles and organic resin particles.
As the inorganic particles, known particles may be used, and examples thereof include carbon nanotubes, fullerene, graphite, silica, alumina, aluminum, and calcium carbonate.
As the organic resin particles, known particles may be used, and preferred examples thereof include thermally expandable microcapsules.
As the thermally expandable microcapsules, EXPANCEL (Akzo Noble) can be cited.
The resin composition for laser engraving of the present invention may employ only one type of Component H or two or more types in combination.
The content of the filler (Component H) in the resin composition for laser engraving of the present invention is preferably 0.01 to 20 mass % relative to the total mass of the resin composition, more preferably 0.05 to 10 mass %, and particularly preferably 0.1 to 5 mass %.

(Component I) Binder polymer other than Component A

The resin composition for laser engraving of the present invention may comprise (Component I) a binder polymer other than Component A (hereinafter, also called simply a 'binder polymer') that is a resin component other than Component A, but the content thereof is preferably less than the content of Component A, more preferably no greater than 50 mass% of the content of Component A, yet more preferably no greater than 10 mass%, and particularly preferably none, that is, the binder polymer other than Component A (Component I) being not contained.
The binder polymer is a polymer component contained in the resin composition for laser engraving; a usual polymer compound is appropriately selected, and one type may be used on its own or two or more types may be used in combination. In particular, when the resin composition for laser engraving is used in a printing plate precursor, it is preferably selected while taking into consideration various aspects of performance such as laser engraving properties, ink acceptance/transfer, and engraving residue dispersibility.
Examples of the binder polymer include binder polymers described in paragraphs 0009 to 0030 of JP-A-2012-045801.
The resin composition for laser engraving of the present invention may employ only one type of Component I or two or more types in combination.

<Other additives>

To the resin composition for laser engraving of the present invention, additives other than Component A to

Component I may be added suitably in a range that does not hinder the effect of the present invention. Examples thereof include a thickener, a surfactant, wax, a process oil, a metal oxide, an ozone decomposition inhibitor, an antioxidant, a thermal polymerization inhibitor, a colorant, an alcohol exchange reaction catalyst, etc. With regard to these additives, only one type may be used or two or more types may be used in combination.

The resin composition for laser engraving of the present invention may comprise, as an additive for improving engraving sensitivity, nitrocellulose or a high thermal conductivity material.

Since nitrocellulose is a self-reactive compound, it generates heat during laser engraving, thus assisting thermal decomposition of a coexisting binder polymer. It is surmised that as a result, the engraving sensitivity improves.

A high thermal conductivity material is added for the purpose of assisting heat transfer, and examples of thermally conductive materials include inorganic compounds such as metal particles and organic compounds such as a conductive polymer. As the metal particles, fine gold particles, fine silver particles, and fine copper particles having a particle diameter of on the order of a micrometer or a few nanometers are preferable. As the conductive polymer, a conjugated polymer is particularly preferable, and specific examples thereof include polyaniline and polythiophene.

Moreover, the use of a cosensitizer can furthermore improve the sensitivity in curing the resin composition for laser engraving with light.

Furthermore, a small amount of thermal polymerization inhibitor is added preferably for the purpose of hindering unnecessary thermal polymerization of a polymerizable compound during the production or storage of the composition.

(Flexographic printing plate precursor for laser engraving)

A first embodiment of the flexographic printing plate precursor for laser engraving of the present invention comprises a relief-forming layer formed from the resin composition for laser engraving of the present invention.

A second embodiment of the flexographic printing plate precursor for laser engraving of the present invention comprises a crosslinked relief-forming layer formed by crosslinking a relief-forming layer formed from the resin composition for laser engraving of the present invention.

In the present invention, the 'flexographic printing plate precursor for laser engraving' means both or one of a flexographic printing plate precursor having a crosslinkable relief-forming layer formed from the resin composition for laser engraving in a state before being crosslinked and a flexographic printing plate precursor in a state in which it is cured by light and/or heat.

In the present invention, the 'relief-forming layer' means a layer in a state before being crosslinked, that is, a layer formed from the resin composition for laser engraving of the present invention, which may be dried as necessary.

In the present invention, the "crosslinked relief-forming layer" refers to a layer obtained by crosslinking the aforementioned relief-forming layer. The crosslinking can be performed by heat and/or light, and the crosslinking by heat is preferable. Moreover, the crosslinking is not particularly limited only if it is a reaction that cures the resin composition, and is a general idea that includes the crosslinked structure by the reaction of Component B with each other, the reaction of Component A with each other, the reaction of Component A with Component B, the reaction of Component B with the other component, the reaction of Component A with the other component, etc.

The 'flexographic printing plate' is made by laser engraving the flexographic printing plate precursor having the crosslinked relief-forming layer.

Moreover, in the present invention, the 'relief layer' means a layer of the flexographic printing plate formed by engraving using a laser, that is, the crosslinked relief-forming layer after laser engraving.

A flexographic printing plate precursor for laser engraving of the present invention comprises a relief-forming layer formed from the resin composition for laser engraving of the present invention, which has the above-mentioned components. The (crosslinked) relief-forming layer is preferably provided above a support.

The flexographic printing plate precursor for laser engraving may further comprise, as necessary, an adhesive layer between the support and the (crosslinked) relief-forming layer and, above the (crosslinked) relief-forming layer, a slip coat layer and a protection film.

<Relief-forming layer>

The relief-forming layer is a layer formed from the resin composition for laser engraving of the present invention, and is preferably crosslinkable by heat.

As a mode in which a flexographic printing plate is prepared using the flexographic printing plate precursor for laser engraving, a mode in which a flexographic printing plate is prepared by crosslinking a relief-forming layer to thus form a flexographic printing plate precursor having a crosslinked relief-forming layer, and the crosslinked relief-forming layer (hard relief-forming layer) is then laser-engraved to thus form a relief layer is preferable. By crosslinking the relief-forming layer, it is possible to prevent abrasion of the relief layer during printing, and it is possible to obtain a flexographic printing plate having a relief layer with a sharp shape after laser engraving.

The relief-forming layer may be formed by molding the resin composition for laser engraving that has the above-mentioned components for a relief-forming layer into a sheet shape or a sleeve shape. The relief-forming layer is usually provided above a support, which is described later, but it may be formed directly on the surface of a member such as a cylinder of equipment for plate producing or printing or may be placed and immobilized thereon, and a support is not always required.
A case in which the relief-forming layer is mainly formed in a sheet shape is explained as an example below.

<Support>

A material used for the support of the flexographic printing plate precursor for laser engraving is not particularly limited, but one having high dimensional stability is preferably used, and examples thereof include metals such as steel, stainless steel, or aluminum, plastic resins such as a polyester (e.g. polyethylene terephthalate (PET), polybutylene terephthalate (PBT), or polyacrylonitrile (PAN)) or polyvinyl chloride, synthetic rubbers such as styrene-butadiene rubber, and glass fiber-reinforced plastic resins (epoxy resin, phenolic resin, etc.). As the support, a PET film or a steel substrate is preferably used. The configuration of the support depends on whether the relief-forming layer is in a sheet shape or a sleeve shape.

<Adhesive layer>

An adhesive layer may be provided between the relief-forming layer and the support for the purpose of strengthening the adhesion between the two layers. Examples of materials (adhesives) that can be used in the adhesive layer include those described in 'Handbook of Adhesives', Second Edition, Ed by I. Skeist, (1977).

<Protection film, slip coat layer>

For the purpose of preventing scratches or dents in the relief-forming layer surface or the crosslinked relief-forming layer surface, a protection film may be provided on the relief-forming layer surface or the crosslinked relief-forming layer surface. The thickness of the protection film is preferably 25 to 500 μm, and more preferably 50 to 200 μm. The protection film may employ, for example, a polyester-based film such as PET or a polyolefin-based film such as PE (polyethylene) or PP (polypropylene). The surface of the film may be made matte. The protection film is preferably peelable.
When the protection film is not peelable or conversely has poor adhesion to the relief-forming layer, a slip coat layer may be provided between the two layers. The material used in the slip coat layer preferably employs as a main component a resin that is soluble or dispersible in water and has little tackiness, such as polyvinyl alcohol, polyvinyl acetate, partially saponified polyvinyl alcohol, a hydroxyalkylcellulose, an alkylcellulose, or a polyamide resin.

(Process for producing flexographic printing plate precursor for laser engraving)

The process for producing a flexographic printing plate precursor for laser engraving is not particularly limited, and examples thereof include a method in which a coating solution of a resin composition for laser engraving is prepared, solvent is removed from this coating solution composition for laser engraving, and it is then melt-extruded onto a support. Alternatively, a method may be employed in which a resin composition for laser engraving is cast onto a support, and this is dried in an oven to thus remove solvent from the resin composition.
Among them, the process for producing a flexographic printing plate precursor for laser engraving of the present invention is preferably a production process comprising a layer formation step of forming a relief-forming layer from the resin composition for laser engraving of the present invention and a crosslinking step of crosslinking the relief-forming layer by means of heat and/or light to thus obtain a flexographic printing plate precursor having a crosslinked relief-forming layer.
Subsequently, as necessary, a protection film may be laminated on the relief-forming layer. Laminating may be carried out by compression-bonding the protection film and the relief-forming layer by means of heated calendar rollers, etc. or putting a protection film into intimate contact with a relief-forming layer whose surface is impregnated with a small amount of solvent.
When a protection film is used, a method in which a relief-forming layer is first layered on a protection film and a support is then laminated may be employed.
When an adhesive layer is provided, it may be dealt with by use of a support coated with an adhesive layer. When a slip coat layer is provided, it may be dealt with by use of a protection film coated with a slip coat layer.

<Layer formation step>

The process for producing a flexographic printing plate precursor for laser engraving of the present invention preferably comprises a layer formation step of forming a relief-forming layer from the resin composition for laser engraving of the present invention.

Preferred examples of a method for forming the relief-forming layer include a method in which the resin composition for laser engraving of the present invention is prepared, solvent is removed as necessary from this resin composition for laser engraving, and it is then melt-extruded onto a support and a method in which the resin composition for laser engraving of the present invention is prepared, is cast onto a support, and this is dried in an oven to thus remove solvent.

The resin composition for laser engraving can be produced by, for example, a method of dissolving or dispersing Component A to Component C, and Component D, Component E, and Component G to Component I as an optional component, and the like in an appropriate solvent and then mixing these solution and/or dispersion. Since it is preferably to remove most of the solvent component in a stage of producing a flexographic printing plate precursor, it is preferable to use as the solvent a volatile low-molecular-weight alcohol (e.g. methanol, ethanol, n-propanol, isopropanol, propylene glycol monomethyl ether), etc., and adjust the temperature, etc. to thus reduce as much as possible the total amount of solvent to be added.

The thickness of the (crosslinked) relief-forming layer in the flexographic printing plate precursor for laser engraving is preferably 0.05 to 10 mm before and after crosslinking, more preferably 0.05 to 7 mm, and yet more preferably 0.05 to 3 mm.

<Crosslinking step>

The process for producing a flexographic printing plate precursor for laser engraving of the present invention is a production process comprising a crosslinking step of crosslinking the relief-forming layer by means of light and/or heat to thus obtain a flexographic printing plate precursor having a crosslinked relief-forming layer.

The crossliking step is preferably a step of crosslinking the relief-forming layer by means of heat.

The relief-forming layer may be crosslinked by heating the flexographic printing plate precursor for laser engraving (step of crosslinking by means of heat). As heating means for carrying out crosslinking by heat, there can be cited a method in which a printing plate precursor is heated in a hot air oven or a far-infrared oven for a predetermined period of time and a method in which it is put into contact with a heated roller for a predetermined period of time.

Due to the relief-forming layer being crosslinked, firstly, a relief formed after laser engraving becomes sharp and, secondly, tackiness of engraving residue formed during laser engraving is suppressed.

In the present invention, in the crosslinking step, polymerization reactions of Component B with each other carry out.

In addition, by using a photopolymerization initiator or the like, the polymerizable compound may be polymerized to form crosslinking, and the crosslinking may be further carried out by means of light (crosslinking step by means of light).

When the relief-forming layer comprises a photopolymerization initiator, the relief-forming layer may be crosslinked by irradiating the relief-forming layer with actinic radiation that triggers the photopolymerization initiator.

It is standard to apply light to the entire surface of the relief-forming layer. Examples of the light (also called 'actinic radiation') include visible light, UV light, and an electron beam, but UV light is most generally used. When the side where there is a substrate, such as a relief-forming layer support, for fixing the relief-forming layer, is defined as the reverse face, only the front face need to be irradiated with light, but when the support is a transparent film through which actinic radiation passes, it is preferable to further irradiate from the reverse face with light as well. When a protection film is present, irradiation from the front face may be carried out with the protection film as it is or after peeling off the protection film. Since there is a possibility of polymerization being inhibited in the presence of oxygen, irradiation with actinic radiation may be carried out after superimposing a polyvinyl chloride sheet on the relief-forming layer and evacuating.

(Flexographic printing plate and process for making same)

The process for making a flexographic printing plate of the present invention preferably comprises a layer formation step of forming a relief-forming layer from the resin composition for laser engraving of the present invention, a crosslinking step of crosslinking the relief-forming layer by means of light and/or heat to thus form a flexographic printing plate precursor having a crosslinked relief-forming layer, and an engraving step of laser-engraving the flexographic printing plate precursor having the crosslinked relief-forming layer. Furthermore, the process preferably comprises a rinsing step of rinsing the surface of the relief layer with a rinsing liquid.

The flexographic printing plate of the present invention is a flexographic printing plate having a relief layer

obtained by crosslinking and laser-engraving a layer formed from the resin composition for laser engraving of the present invention, and is preferably a flexographic printing plate made by the process for producing a flexographic printing plate of the present invention.

The flexographic printing plate of the present invention may suitably be printable by a UV ink and a solvent ink.

The layer formation step and the crosslinking step in the process for producing a flexographic printing plate of the present invention mean the same as the layer formation step and the crosslinking step in the above-mentioned process for producing a flexographic printing plate precursor for laser engraving, and preferred ranges are also the same.

<Engraving step>

The process for producing a flexographic printing plate of the present invention preferably comprises an engraving step of laser-engraving the flexographic printing plate precursor having a crosslinked relief-forming layer.

The engraving step is a step of laser-engraving a crosslinked relief-forming layer that has been crosslinked in the crosslinking step to thus form a relief layer. Specifically, it is preferable to engrave a crosslinked relief-forming layer that has been crosslinked with laser light according to a desired image, thus forming a relief layer. Furthermore, a step in which a crosslinked relief-forming layer is subjected to scanning irradiation by controlling a laser head using a computer in accordance with digital data of a desired image can preferably be cited.

This engraving step preferably employs an infrared laser. When irradiated with an infrared laser, molecules in the crosslinked relief-forming layer undergo molecular vibration, thus generating heat. When a high power laser such as a carbon dioxide laser or a YAG laser is used as the infrared laser, a large quantity of heat is generated in the laser-irradiated area, and molecules in the crosslinked relief-forming layer undergo molecular scission or ionization, thus being selectively removed, that is, engraved. The advantage of laser engraving is that, since the depth of engraving can be set freely, it is possible to control the structure three-dimensionally. For example, for an area where fine halftone dots are printed, carrying out engraving shallowly or with a shoulder prevents the relief from collapsing due to printing pressure, and for a groove area where a fine outline character is printed, carrying out engraving deeply makes it difficult for ink the groove to be blocked with ink, thus enabling breakup of an outline character to be suppressed.

In particular, when engraving is carried out using an infrared laser that corresponds to the absorption wavelength of the photothermal conversion agent, it becomes possible to selectively remove the crosslinked relief-forming layer at higher sensitivity, thus giving a relief layer having a sharp image.

As the infrared laser used in the engraving step, from the viewpoint of productivity, cost, etc., a carbon dioxide laser (a CO2 laser) or a semiconductor laser is preferable. In particular, a fiber-coupled semiconductor infrared laser (FC-LD) is preferably used. In general, compared with a CO2 laser, a semiconductor laser has higher efficiency laser oscillation, is less expensive, and can be made smaller. Furthermore, it is easy to form an array due to the small size. Moreover, the shape of the beam can be controlled by treatment of the fiber.

With regard to the semiconductor laser, one having a wavelength of 700 to 1,300 nm is preferable, one having a wavelength of 800 to 1,200 nm is more preferable, one having a wavelength of 860 to 1,200 nm is yet more preferable, and one having a wavelength of 900 to 1,100 nm is particularly preferable.

Furthermore, the fiber-coupled semiconductor laser can output laser light efficiently by being equipped with optical fiber, and this is effective in the engraving step in the present invention. Moreover, the shape of the beam can be controlled by treatment of the fiber. For example, the beam profile may be a top hat shape, and energy can be applied stably to the plate face. Details of semiconductor lasers are described in 'Laser Handbook 2nd Edition' The Laser Society of Japan, Applied Laser Technology, The Institute of Electronics and Communication Engineers, etc.

Moreover, as plate making equipment comprising a fiber-coupled semiconductor laser that can be used suitably in the process for making a flexographic printing plate employing the flexographic printing plate precursor of the present invention, those described in detail in JP-A-2009-172658 and JP-A-2009-214334 can be cited. Such equipment comprising a fiber-coupled semiconductor laser can be used to produce a flexographic printing plate of the present invention.

<Rinsing step, drying step, and post-crosslinking step>

The process for producing a flexographic printing plate of the present invention may as necessary further comprise, subsequent to the engraving step, a rinsing step, a drying step, and/or a post-crosslinking step, which are shown below.

Rinsing step: a step of rinsing the engraved surface by rinsing the engraved relief layer surface with water or a liquid comprising water as a main component.

Drying step: a step of drying the engraved relief layer.

Post-crosslinking step: a step of further crosslinking the relief layer by applying energy to the engraved relief layer.

After the above-mentioned step, since engraved residue is attached to the engraved surface, a rinsing step of

washing off engraved residue by rinsing the engraved surface with water or a liquid comprising water as a main component may be added. Examples of rinsing means include a method in which washing is carried out with tap water, a method in which high pressure water is spray-jetted, and a method in which the engraved surface is brushed in the presence of mainly water using a batch or conveyor brush type washout machine known as a photosensitive resin letterpress plate processor, and when slime due to engraved residue cannot be eliminated, a rinsing liquid to which a soap or a surfactant is added may be used.

When the rinsing step of rinsing the engraved surface is carried out, it is preferable to add a drying step of drying an engraved relief-forming layer so as to evaporate rinsing liquid.

Furthermore, as necessary, a post-crosslinking step for further crosslinking the relief-forming layer may be added. By carrying out a post-crosslinking step, which is an additional crosslinking step, it is possible to further strengthen the relief formed by engraving.

The pH of the rinsing liquid that can be used in the present invention is preferably 7 to 14, more preferably 8 to 13, yet more preferably 9 to 12, and particularly preferably 9 to 11. When in the above-mentioned range, the advantageous effects of the present invention can be more efficiently exhibited.

The pH of the rinsing is preferably at least 10. When in the above-mentioned range, rinsing properties for engraving residue when laser engraving are more excellent.

In order to set the pH of the rinsing liquid in the above-mentioned range, the pH may be adjusted using an acid and/or a base as appropriate, and the acid or base used is not particularly limited. From the viewpoint of cost, etc., preferred examples of the base include a hydroxide of an alkali metal or an alkaline earth metal.

The rinsing liquid that can be used in the present invention is preferably aqueous rinsing liquid comprising water as a main component.

The rinsing liquid may comprise as a solvent other than water a water-miscible solvent such as an alcohol, acetone, or tetrahydrofuran.

The rinsing liquid preferably comprises a surfactant.

From the viewpoint of removability of engraved residue and little influence on a flexographic printing plate, preferred examples of the surfactant that can be used in the present invention include amphoteric surfactants, and preferred examples of the amphoteric surfactant include a betaine compound such as a carboxybetaine compound, a sulfobetaine compound, a phosphobetaine compound, and an amine oxide compound, and a phosphine oxide compound.

The amphoteric surfactant is preferably a compound represented by Formula (Be-1) below and/or a compound represented by Formula (Be-2) below.

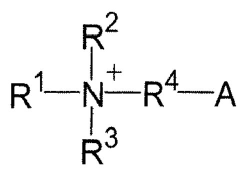

(Be - 1)

In Formula (Be-1), $R^1$ to $R^3$ independently denote a monovalent organic group, $R^4$ denotes a single bond or a divalent linking group, A denotes $PO(OR^5)O^-$, $OPO(OR^5)O^-$, $O^-$, $COO^-$, or $SO_3^-$ $R^5$ denotes a hydrogen atom or a monovalent organic group, and two or more groups of $R^1$ to $R^3$ may be bonded to each other to form a ring.

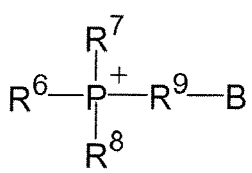

(Be - 2)

In Formula (Be-2), $R^6$ to $R^8$ independently denote a monovalent organic group, $R^9$ denotes a single bond or a divalent linking group, B denotes $PO(OR^{10})O^-$, $OPO(OR^{10})O$-, $O^-$, $COO^-$, or $SO_3^-$, $R^{10}$ denotes a hydrogen atom or a monovalent organic group, and two or more groups of $R^6$ to $R^8$ may be bonded to each other to form a ring.

The compound represented by Formula (Be-1) above or the compound represented by Formula (Be-2) above is preferably a carboxybetaine compound, a sulfobetaine compound, a phosphobetaine compound, an amine oxide compound, or a phosphine oxide compound. In the present invention, the structures of N=O of an amine oxide compound and P=O of a phosphine oxide compound are considered to be $N^+$-$O^-$ and $P$ $^+$-$O^-$ respectively.

$R^1$ to $R^3$ in Formula (Be-1) above independently denote a monovalent organic group. Two or more groups of $R^1$ to $R^3$ may be bonded to each other to form a ring, but it is preferable that no ring is formed.

The monovalent organic group denoted by $R^1$ to $R^3$ is not particularly limited, but is preferably an alkyl group, a hydroxy group-containing alkyl group, an alkyl group having an amide bond in an alkyl chain, or an alkyl group having an ether bond in an alkyl chain, and is more preferably an alkyl group, a hydroxy group-containing alkyl group, or an alkyl group having an amide bond in an alkyl chain.

Furthermore, the alkyl group as the monovalent organic group may have a straight chain, branched, or cyclic structure.

Moreover, it is particularly preferable that two of $R^1$ to $R^3$ are methyl groups, that is, a compound represented by Formula (Be-1) has an N,N-dimethyl structure. When it has the above-mentioned structure, particularly good rinsing properties are exhibited.

$R^4$ in Formula (Be-1) above denotes a single bond or a divalent linking group, and is a single bond when a compound represented by Formula (Be-1) is an amine oxide compound.

The divalent linking group denoted by $R^4$ is not particularly limited, and is preferably an alkylene group or a hydroxy group-containing alkylene group, more preferably an alkylene group having 1 to 8 carbon atoms or a hydroxy group-containing alkylene group having 1 to 8 carbon atoms, and yet more preferably an alkylene group having 1 to 3 carbon atoms or a hydroxy group-containing-alkylene group having 1 to 3 carbon atoms.

A in Formula (Be-1) above denotes $PO(OR^5)O^-$, $OPO(OR^5)O^-$, $O^-$, $COO^-$, or $SO_3^-$, and is preferably $O^-$, $COO^-$, or $SO_3^-$, and more preferably $COO^-$.

When A is $O^-$, $R^4$ is preferably a single bond.

$R^5$ in $PO(OR^5)O^-$ and $OPO(OR^5)O^-$ denotes a hydrogen atom or a monovalent organic group, and is preferably a hydrogen atom or an alkyl group having one or more unsaturated fatty acid ester structures.

Furthermore, $R^4$ is preferably a group that does not have $PO(OR^5)O^-$, $OPO(OR^5)O^-$, $O^-$, $COO^-$, or $SO_3^-$.

$R^6$ to $R^8$ in Formula (Be-2) above independently denote a monovalent organic group. Two or more groups of $R^6$ to $R^8$ may be bonded to each other to form a ring, but it is preferable that no ring is formed.

The monovalent organic group denoted by $R^6$ to $R^8$ is not particularly limited, but is preferably an alkyl group, an alkenyl group, an aryl group, or a hydroxy group, and more preferably an alkenyl group, an aryl group, or a hydroxy group.

Furthermore, the alkyl group as the monovalent organic group may have a straight chain, branched, or cyclic structure.

It is particularly preferable that two of $R^6$ to $R^8$ are aryl groups.

It is particularly preferable that two of $R^6$ to $R^8$ are aryl groups.

$R^9$ in Formula (Be-2) above denotes a single bond or a divalent linking group, and is a single bond when a compound represented by Formula (Be-2) is a phosphine oxide compound.

The divalent linking group denoted by $R^9$ is not particularly limited, but is preferably an alkylene group or a hydroxy group-containing alkylene group, more preferably an alkylene group having 1 to 8 carbon atoms or a hydroxy group-containing alkylene group having 1 to 8 carbon atoms, and yet more preferably an alkylene group having 1 to 3 carbon atoms or a hydroxy group-containing alkylene group having 1 to 3 carbon atoms.

B in Formula (Be-2) above denotes $PO(OR^{10})O^-$, $OPO(OR^{10})O^-$, $O^-$, $COO^-$, or $SO_3^-$, and is preferably $O^-$.

$R^9$ is preferably a single bond when B is $O^-$.

$R^{10}$ in $PO(OR^{10})O^-$ and $OPO(OR^{10})O^-$ denotes a hydrogen atom or a monovalent organic group, and is preferably a hydrogen atom or an alkyl group having one or more unsaturated fatty acid ester structures.

Furthermore, $R^9$ is preferably a group that does not have $PO(OR^{10})O^-$, $OPO(OR^{10})O^-$ $O^-$, $COO^-$, or $SO_3^-$.

A compound represented by Formula (Be-1) is preferably a compound represented by Formula (Be-3) below.

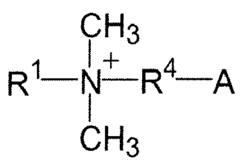

( Be - 3 )

In Formula (Be-3), $R^1$ denotes a monovalent organic group, $R^4$ denotes a single bond or a divalent linking group, A denotes $PO(OR^5)O^-$, $OPO(OR^5)O^-$ $O^-$, $COO^-$, or $SO_3^-$, and $R^5$ denotes a hydrogen atom or a monovalent organic group.

$R^1$, A, and $R^5$ in Formula (Be-3) have the same meanings as $R^1$, A, and $R^5$ in Formula (Be-1) above, and preferred ranges are also the same.

A compound represented by Formula (Be-2) is preferably a compound represented by Formula (Be-4) below.

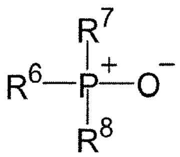

(Be - 4)

In Formula (Be-4), $R^6$ to $R^8$ independently denote an alkyl group, an alkenyl group, an aryl group, or a hydroxy group. In addition, not all of $R^6$ to $R^8$ are the same groups.

$R^6$ to $R^8$ in Formula (Be-4) above independently denote an alkyl group, an alkenyl group, an aryl group, or a hydroxy group, and are preferably an alkenyl group, an aryl group, or a hydroxy group.

Specific examples of the compound represented by Formula (Be-1) and the compound represented by Formula (Be-2) include the compounds below.

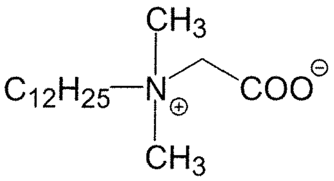

(1 - A)

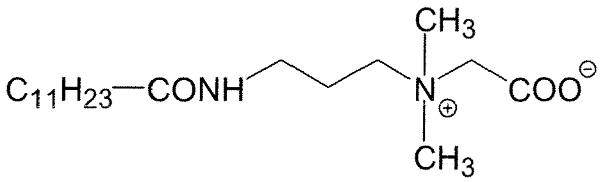

(1 - B)

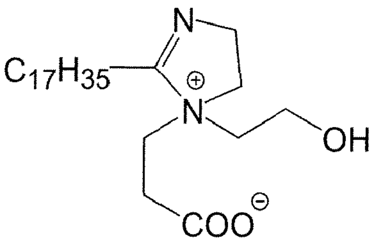

(1 - C)

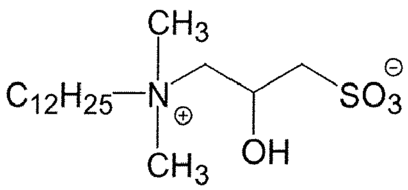

(1 - D)

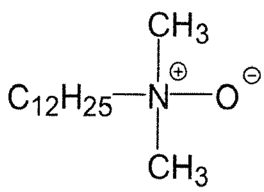

(1 - E)

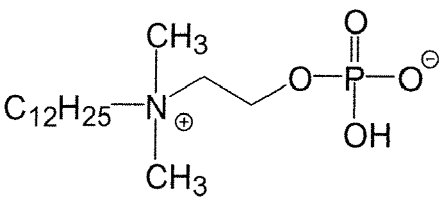

(1 - F)

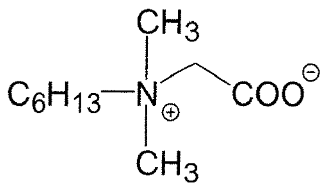

(1 - G)

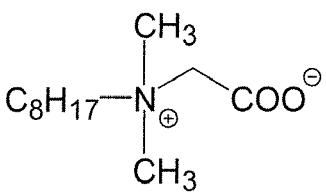

(1 - H)

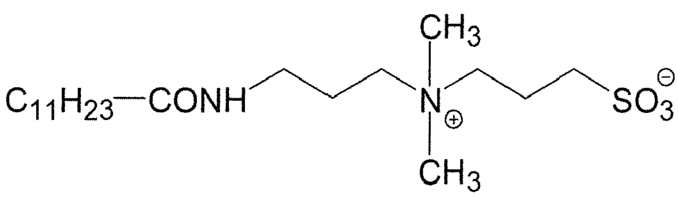

(1 - I)

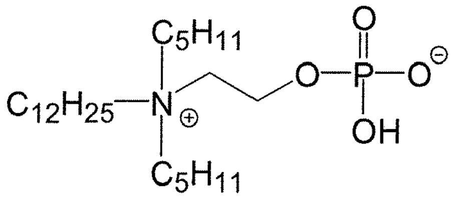

( 1 - J )

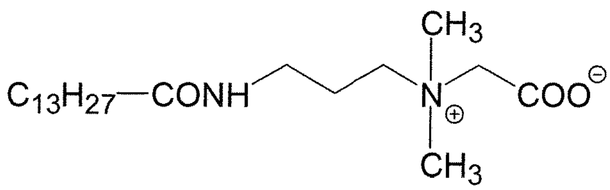

( 1 - K )

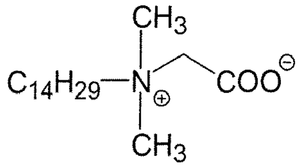

( 1 - L )

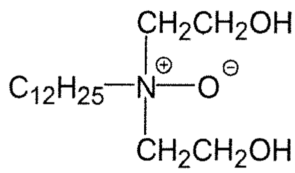

( 1 - M )

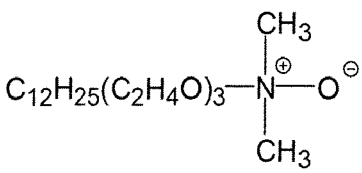

( 1 - N )

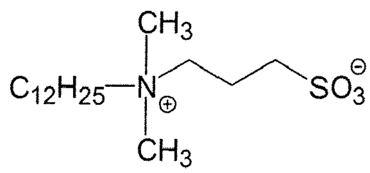

( 1 - O )

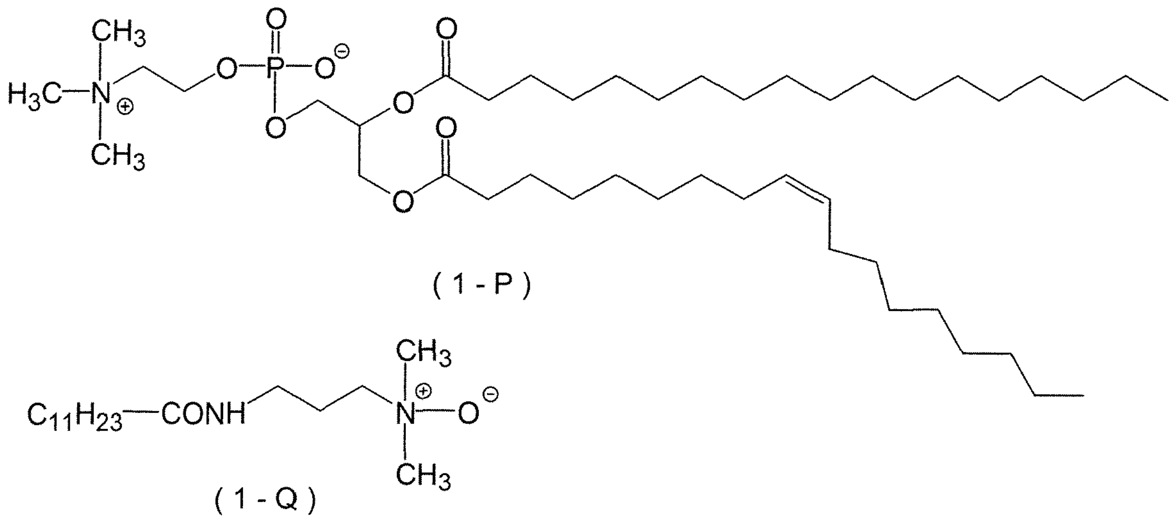

( 1 - P )

( 1 - Q )

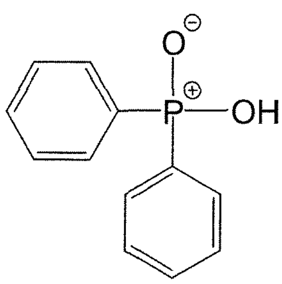

( 2 - A )

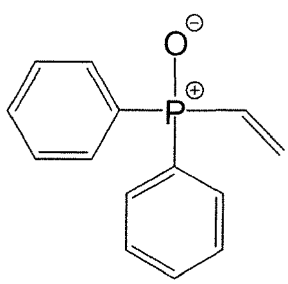

( 2 - B )

Furthermore, examples of the surfactant also include known anionic surfactants, cationic surfactants, and nonionic surfactants. Moreover, a fluorine-based or silicone-based nonionic surfactant may also be used in the same manner.

With regard to the surfactant, one type may be used on its own or two or more types may be used in combination.

It is not necessary to particularly limit the amount of surfactant used, but it is preferably 0.01 to 20 mass % relative to the total mass of the rinsing liquid, and more preferably 0.05 to 10 mass %.

The flexographic printing plate of the present invention having a relief layer above the surface of an optional substrate such as a support may be produced as described above.

From the viewpoint of satisfying suitability for various aspects of printing, such as abrasion resistance and ink transfer properties, the thickness of the relief layer of the flexographic printing plate is preferably at least 0.05 mm but no greater than 10 mm, more preferably at least 0.05 mm but no greater than 7 mm, and yet more preferably at least 0.05 mm but no greater than 3 mm.

Furthermore, the Shore A hardness of the relief layer of the flexographic printing plate is preferably at least 50° but no greater than 90°. When the Shore A hardness of the relief layer is at least 50°, even if fine halftone dots formed by engraving receive a strong printing pressure from a letterpress printer, they do not collapse and close up, and normal printing can be carried out. Furthermore, when the Shore A hardness of the relief layer is no greater than 90°, even for flexographic printing with kiss touch printing pressure it is possible to prevent patchy printing in a solid printed part.

The Shore A hardness in the present specification is a value measured by a durometer (a spring type rubber hardness meter) that presses an indenter (called a pressing needle or indenter) into the surface of a measurement target at 25°C so as to deform it, measures the amount of deformation (indentation depth), and converts it into a numerical value.

The flexographic printing plate of the present invention is available when it is carried out by a letterpress printer using any of aqueous and oil-based inks, and printing is also possible when it is carried out by a flexographic printer using a UV ink. The flexographic printing plate of the present invention has excellent rinsing properties, remained engraving residue is reduced, the obtained relief-layer has excellent printing durability, and printing can be carried out for a long period of time without plastic deformation of the relief layer or degradation of printing durability.

According to the present invention, it is possible to provide a resin composition for laser engraving that is excellent in rinsing properties for engraving residue generated by laser engraving and can give a plate exhibiting excellent ink resistance with respect to various inks, a flexographic printing plate precursor for laser engraving that uses the resin composition for laser engraving and a process for producing the precursor, and a flexographic printing plate and a process for making the plate.

EXAMPLE

The present invention is explained in further detail below by reference to Examples, but the present invention should not be construed as being limited to these Examples. Furthermore, 'parts' in the description below means 'parts by mass', and '%' means 'mass %', unless otherwise specified.

Moreover, the weight-average molecular weight (Mw) and the number-average molecular weight (Mn) of a polymer in the Examples are values measured by a Gel Permeation Chromatography (GPC) method (eluent: tetrahydrofuran) unless otherwise specified.

(Synthesis examples)

<Synthesis of 1-2>

GI-3000 (hydrogenated polybutadiene diol, Mn = 3,100, manufactured by Wako Pure Chemical Industries, Ltd.) (72 g, 89 mass%) was dissolved in PGMEA (propylene glycol monomethyl ether acetate, manufactured by Wako Pure Chemical Industries, Ltd.) (20.4 g). After dissolution, DMBA (2,2-bis(hydroxymethyl) butyrate, manufactured by Wako Pure Chemical Industries, Ltd.) (0.57 g, 0.7 mass%) and IPDI (isophorone diisocyanate, manufactured by Wako Pure Chemical Industries, Ltd.) (7 g, 8.6 mass%) were added to and dissolved in the solution. After the above components were evenly dissolved, butyltin dilaurate (0.5 g) was added to the solution and reacted for 5 hours at 70°C. After the reaction, HEA (2-hydroxyethyl acrylate, manufactured by Wako Pure Chemical Industries, Ltd.) (1.4 g, 1.7 mass%) was added thereto and reacted for 3 hours at 70°C, thereby obtaining A1-2 (GI-3000-DMBA (0.7 mass%)-IPDI-HEA). The structure of A1-2 was identified by $^{1}H$-NMR and IR spectroscopy. The weight average molecular weight of A1-2 was 30,000.

<Synthesis of A1-1 and A1-3 to A1-10>

A1-1 and A1-3 to A1-10 were synthesized in the same manner as in the Synthesis of A1-2, except that the

amount of DMBA and GI-3000 added were adjusted such that the amount of DMBA added was changed as described below, and/or GI-3000 was replaced with GI-2000 (hydrogenated polybutadiene diol, Mn = 2,100, manufactured by Wako Pure Chemical Industries, Ltd.).
A1-1: GI-3000-IPDI-HEA (Mw: 30,000)
A1-3: GI-3000-DMBA (3 mass%)-IPDI-HEA (Mw: 32,000)
A1-4: GI-3000-DMBA (11 mass%)-IPDI-HEA (Mw: 30,000)
A1-5: GI-3000-DMBA (16 mass%)-IPDI-HEA (Mw: 27,000)
A1-6: GI-2000-IPDI-HEA (Mw: 33,000)
A1-7: GI-2000-DMBA (1 mass%)-IPDI-HEA (Mw: 33,000)
A1-8: GI-2000-DMBA (6 mass%)-IPDI-HEA (Mw: 32,000)
A1-9: GI-2000-DMBA (12 mass%)-IPDI-HEA (Mw: 29,000)
A1-10: GI-2000-DMBA (17 mass%)-IPDI-HEA (Mw: 29,000)

<Synthesis of A1-12>

LIR-30 (liquid polyisoprene rubber, Mn = 28,000, manufactured by KURARAY CO., LTD.) (99.5 g, 99.5 mass%) was put into a pressure kneader heated to 90°C and subjected to mastication for several minutes. Thereafter, *N*-phenyl-N'-(1,3-dimethylbutyl)-*p*-phenylenediamine (1 g) as an antioxidant, xylene (1 g), and maleic anhydride (0.5 g, 0.5 mass%) were added thereto, followed by kneading for 30 minutes at 90°C. Subsequently, the kneader was heated to 200°C, and kneading was performed for 1 hour, thereby obtaining A1-12 (LIR-30 modified with 0.5 mass% maleic anhydride). The structure of A1-12 was identified by $^1$H-NMR.

<Synthesis of A1-11 and A1-13 to A1-25>

A1-11 and A1-13 to A1-25 were synthesized in the same manner as in the Synthesis of A1-12, except that the amount of maleic anhydride added was changed as described below, and/or LIR-30 was replaced with LIR390 or UBEPOL BR150.
LIR-390 (liquid isoprene-butadiene copolymer, Mn = 48,000, manufactured by KURARAY CO., LTD.)
UBEPOL BR150 (polybutadiene rubber, Mooney viscosity ML (1 + 4) 100°C = 62, Mw = 563,000, Mn = 206,000, manufactured by UBE INDUSTRIES, LTD.)
A1-11: LIR-30 modified with 0.05 mass% maleic anhydride
A1-13: LIR-30 modified with 5 mass% maleic anhydride
A1-14: LIR-30 modified with 10 mass% maleic anhydride
A1-15: LIR-30 modified with 16 mass% maleic anhydride
A1-16: LIR-390 modified with 0.05 mass% maleic anhydride
A1-17: LIR-390 modified with 0.5 mass% maleic anhydride
A1-18: LIR-390 modified with 5 mass% maleic anhydride
A1-19: LIR-390 modified with 10 mass% maleic anhydride
A1-20: LIR-390 modified with 16 mass% maleic anhydride
A1-21: UBEPOL BR150 modified with 0.05 mass% maleic anhydride
A1-22: UBEPOL BR150 modified with 0.5 mass% maleic anhydride
A1-23: UBEPOL BR150 modified with 5 mass% maleic anhydride
A1-24: UBEPOL BR150 modified with 10 mass% maleic anhydride
A1-25: UBEPOL BR150 modified with 16 mass% maleic anhydride

<Synthesis of A1-26 to A1-30>

A1-26 to A1-30 were synthesized in the same manner as in the Synthesis of A1-2, except that GI-3000 was replaced with KF-6001 (polydimethyl silicone modified with carbinol at both terminals, hydroxy group equivalent: 900 g/mol, manufactured by Shin-Etsu Chemical Co., Ltd.), and as necessary, the amount of DMBA and GI-3000 added was adjusted such that the amount of DMBA added became as described below.
A1-26: KF-6001-IPDI-HEA (Mw: 30,000)
A1-27: KF-6001-DMBA (0.3 mass%)-IPDI-HEA (Mw: 30,000)
A1-28: KF-6001-DMBA (4 mass%)-IPDI-HEA (Mw: 32,000)
A1-29: KF-6001-DMBA (11 mass%)-IPDI-HEA (Mw: 30,000)
A1-30: KF-6001-DMBA (16 mass%)-IPDI-HEA (Mw: 27,000)

<A1-31>

The following compound was used.

A1-31: JSR N280 (liquid butadiene-acrylonitrile copolymer, manufactured by JSR Corporation)

<Synthesis of A1-32 to A1-36>

A1-32 to A1-36 were synthesized in the same manner as in the Synthesis of A1-12, except that LIR-30 was replaced with JSR N280, and as necessary, the amount of maleic anhydride added was changed as described below.
A1-32: JSR N280 modified with 0.05 mass% maleic anhydride
A1-33: JSR N280 modified with 0.5 mass% maleic anhydride
A1-34: JSR N280 modified with 5 mass% maleic anhydride
A1-35: JSR N280 modified with 10 mass% maleic anhydride
A1-36: JSR N280 modified with 16 mass% maleic anhydride

The amount of maleic anhydride used for modifying the polymer as above is the amount of the used maleic anhydride relative to a total mass of the obtained polymer. For example, A1-11 is a modified polymer prepared using 99.95 mass% of LIR-30 and 0.05 mass% of maleic anhydride.

<Synthesis of A1-37>

UBEPOL BR150 (20 g) and THF (80 g) were put into a three-neck flask, and then UBEPOL BR 150 was evenly dissolved. After dissolution, 3-mercaptopropionic acid (0.01 g) and V-601 (0.2 g) were added thereto, and in a nitrogen atmosphere, the resultant was reacted for 12 hours at 60°C. The reaction solution was reprecipitated in methanol and dried, thereby obtaining A1-37 (BR-150 modified with 0.05 mass% 3-mercaptopropionic acid). The structure of A1-37 was identified by $^1$H-NMR and IR.

<Synthesis of A1-38 to A1-41 >

A1-38 to A1-41 were synthesized in the same manner as in the Synthesis of A1-37, except that the amount of 3-mercaptopropionic acid added was changed as described below.
A1-38: UBEPOL BR150 modified with 0.5 mass% 3-mercaptopropionic acid
A1-39: UBEPOL BR150 modified with 5 mass% 3-mercaptopropionic acid
A1-40: UBEPOL BR150 modified with 10 mass% 3-mercaptopropionic acid
A1-41: UBEPOL BR150 modified with 16 mass% 3-mercaptopropionic acid

Each of A1-1 to A1-41 was a polymer having properties in which when a tensile test was performed on the polymer at 20°C based on the tensile permanent set test of JIS K 6262-1997, the polymer could be stretched by two times the gauge length of a dumbbell test specimen type 4 specified in JIS K 6251-1993, which had not been subjected to a tensile test, and after the polymer was kept as they are for 60 minutes from the point in time when it was stretched by 2 times the gauge length measured before the tensile test, a degree of tensile permanent set of the polymer became at least 30% after 5 minutes elapsed from when the application of an external tensile strength was removed, or alternatively, each of A1-1 to A1-41 was a polymer that was deformed and did not restore its original shape even when an external tensile strength was not applied thereto in the aforementioned tensile test or a polymer that was ruptured by an external tensile strength applied thereto. That is, A1-1 to A1-41 were plastomers at 20°C.

(Examples 1 to 74 and Comparative Example 1 to 34)

1. Preparation of resin composition for laser engraving

As Component A and Component B, the compounds shown in Table 1 to Table 4 in the amount shown in the tables were put into a three-neck flask equipped with a stirring blade and a cooling tube, and 10 mass% of Component D (carbon black #45L: manufactured by Mitsubishi Chemical Corporation, particle diameter: 24 nm, specific surface area: 125 $m^2$/g, DBP oil absorption number: 45 $cm^3$/100 g) was put into the flask. Moreover, as necessary, as Component E, the compounds shown in Table 1 to Table 4 in the amount shown in the tables were put into the flask, and the mixed solution was heated for 30 minutes at 70°C under stirring.

Thereafter, the mixed solution was cooled to 40°C, and 1 mass% of Component C (Perbutyl Z: t-butylperoxybenzoate, manufactured by NOF CORPORATION) was added thereto and stirred for 30 minutes.

By the operation, coating solutions for a crosslinkable relief-forming layer having fluidity (resin compositions for laser engraving) were obtained respectively.

2. Preparation of relief printing plate precursor for laser engraving

A spacer (frame) having a predetermined thickness was placed on a PET substrate. Thereafter, each of the resin compositions for laser engraving of Examples 1 to 74 and Comparative Examples 1 to 34 obtained as above was gently cast such that it did not overflow from the spacer (frame), and heated in an oven at 120°C so as to provide a relief-forming layer having a thickness of about 1 mm. In this manner, relief printing plate precursors for laser engraving were prepared respectively. At this time, heating was performed in the oven at 120°C (nitrogen atmosphere) until surface tackiness completely disappeared, such that thermal crosslinking occurred.

3. Preparation of flexographic printing plate

Each of the crosslinked relief-forming layers was engraved using two types of lasers described below.
As a carbon dioxide laser engraving machine, a high-quality $CO_2$ laser marker ML-9100 series (manufactured by Keyence Corporation) was used to perform engraving by laser irradiation. In the flexographic printing plate precursor for laser engraving, a solid area of 1 $cm^2$ was subjected to raster engraving by the carbon dioxide laser engraving machine, under conditions of an output of 12 W, a head speed of 200 mm/sec, and a pitch setting of 2,400 DPI.
As a semiconductor laser engraving machine, a laser recording device equipped with a fiber-coupled semiconductor laser (FC-LD) SDL-6390 (manufactured by JDS Uniphase Corporation, wavelength of 915 nm) with a maximum output of 8.0 W was used. The semiconductor laser engraving machine was used to raster-engrave a solid area of 1 $cm^2$ under conditions of a laser output of 7.5 W, a head speed of 409 mm/sec, and a pitch setting of 2,400 DPI.

4. Evaluation of flexographic printing plate

The performance of the flexographic printing plate was evaluated in terms of the following items. The results are shown in Table 1 to Table 4.

<Evaluation for swelling rate (evaluation for ink resistance)>

The relief printing plate precursor was cut in the form of a square having a side of about 1 cm and put into a sample bottle. 2 mL of various solvents were put into the bottle, and the bottle was allowed to standstill at 20°C. After 24 hours, the relief printing plate precursor was taken out, and the surface thereof was wiped. Then, the mass of the wiped precursor was measured, and a swelling rate was calculated by the following formula.

$$\text{Swelling rate (mass\%)} = \text{(mass measured after immersion)/(mass measured before immersion)} \times 100$$

As the value becomes close to 100 mass%, it shows that the swelling rate is excellent.
The evaluation criteria are shown below.

4: The swelling rate is less than 105 mass%.
3: The swelling rate is equal to or more than 105 mass% but less than 110 mass%.
2: The swelling rate is equal to or more than 110 mass% but less than 115 mass%.
1: The swelling rate is equal to or more than 115 mass%.

Various inks used are shown below.
Solvent ink: XA-55 (indigo) RE-28 (manufactured by SAKATA INX CORPORATION, SP value of 8.5 to 11.5)
UV ink: UV Flexographic Indigo PHA (manufactured by T&K TOKA Corporation, SP value of 9.2 to 11.1)
Aqueous ink: Aqua SPZ16 Crimson (manufactured by TOYO INK CO., LTD., SP value of 11.5 to 23.4)

<Evaluation for rinsing properties>

The laser-engraved plate was immersed in a rinsing liquid, and the engraved portion was rubbed 10 times against a toothbrush (manufactured by Lion Corporation, Clinica toothbrush flat). Thereafter, the surface of relief layer was observed with an optical microscope so as to check the presence of residues. A plate having no residues was given a 4, a plate practically having no residues was given a 3, a plate having a small amount of residues was given a 2, and a plate from which residues could not be removed was given a 1.
As the rinsing liquid, two types shown below were used.

-Rinsing liquid with pH of less than 10-

Water, a 10 mass% aqueous sodium hydroxide solution, and a betaine compound (1-A) shown below were mixed together to prepare a rinsing liquid which had pH of 9 and contained the betaine compound (1-A) in an amount of 1 mass% of the entirety of the rinsing liquid.

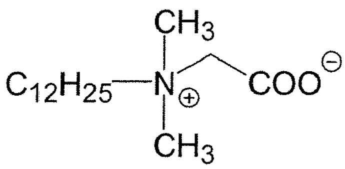

( I - A )

-Rinsing liquid with pH of no less than 10-

Water, a 10 mass% aqueous sodium hydroxide solution, and a betaine compound (1-B) shown below were mixed together to prepare a rinsing liquid which had pH of 12 and contained the betaine compound (1-B) in an amount of 1 mass% of the entirety of the rinsing liquid.

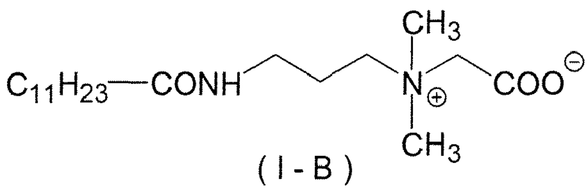

( I - B )

<Evaluation for time-related printing durability>

The laser-engraved plate, which had been left at room temperature (10°C to 30°C) for 3 months, was set in a printer (ITM-4 model, manufactured by IYO KIKAI SEISAKUSHO Co., Ltd.). As an ink, an aqueous ink (Aqua SPZ 16 Crimson (manufactured by TOYO INK CO., LTD.), a UV ink (UV Flexographic Indigo PHA (manufactured by T&K TOKA Corporation), or a solvent ink (XA-55 (indigo) RE-28, manufactured by SAKATA INX CORPORATION) was used to continuously perform printing on printing paper (Full Color Form M70 (manufactured by NIPPON PAPER INDUSTRIES CO., LTD., thickness of 100 μm)), and printed matters with a highlight of 1 to 10% were checked respectively. A point in time when a halftone dot was not printed was taken as a printing end-point, and the length (meter) of the paper used for printing the end-point was taken as an index. The plate in which the printing length was reduced equal to or more than 5% before and after the time elapse in any of the printed matters obtained using various inks was given a 1 in terms of time-related printing durability, and the plate in which the reduction in printing length was less than 5% before and after the time elapse in all of the printed matters obtained using various inks was given a 2 in terms of time-related printing durability.

(Table 1)

| | Component A | | | Component B | | Ink resistance (swelling rate) | | | Rinsing properties for engraving residue | |
|---|---|---|---|---|---|---|---|---|---|---|
| | Resin | Mass % | Content of constitutional repeating unit having acid group (mass%) | Polymerizable compound | Mass % | Solvent | UV | Aqueous | pH <10 | pH ≥10 |
| Comp. Ex. 1 | A1-1 | 75 | 0 | HDDA | 14 | 4 | 4 | 4 | 1 | 1 |
| Ex. 1 | A1-2 | 75 | 0.7 | HDDA | 14 | 4 | 3 | 4 | 3 | 4 |
| Ex. 2 | A1-3 | 75 | 3 | HDDA | 14 | 3 | 4 | 4 | 3 | 4 |
| Ex. 3 | A1-4 | 75 | 11 | HDDA | 14 | 3 | 4 | 4 | 4 | 4 |
| Comp. Ex. 2 | A1-5 | 75 | 16 | HDDA | 14 | 2 | 2 | 3 | 4 | 4 |
| Comp. Ex. 3 | A1-1 | 75 | 0 | TEGDMA | 14 | 4 | 4 | 4 | 1 | 1 |
| Ex.4 | A1-2 | 75 | 0.7 | TEGDMA | 14 | 4 | 4 | 4 | 3 | 4 |
| Ex. 5 | A1-3 | 75 | 3 | TEGDMA | 14 | 4 | 4 | 4 | 3 | 4 |
| Ex. 6 | A1-4 | 75 | 11 | TEGDMA | 14 | 3 | 3 | 3 | 4 | 4 |
| Comp. Ex. 4 | A1-5 | 75 | 16 | TEGDMA | 14 | 1 | 2 | 3 | 4 | 4 |
| Comp. Ex. 5 | A1-6 | 75 | 0 | HDDA | 14 | 4 | 4 | 4 | 1 | 1 |
| Ex. 7 | A1-7 | 75 | 1 | HDDA | 14 | 4 | 4 | 4 | 3 | 4 |
| Ex. 8 | A1-8 | 75 | 6 | HDDA | 14 | 3 | 4 | 4 | 3 | 4 |
| Ex. 9 | A1-9 | 75 | 12 | HDDA | 14 | 3 | 3 | 4 | 3 | 4 |
| Comp. Ex. 6 | A1-10 | 75 | 17 | HDDA | 14 | 1 | 2 | 4 | 3 | 4 |
| Comp. Ex. 7 | A1-6 | 75 | 0 | TEGDMA | 14 | 4 | 4 | 4 | 1 | 1 |
| Ex. 10 | A1-7 | 75 | 1 | TEGDMA | 14 | 3 | 4 | 4 | 3 | 3 |
| Ex. 11 | A1-8 | 75 | 6 | TEGDMA | 14 | 3 | 4 | 4 | 3 | 3 |

(continued)

| | Component A | | | Component B | | Ink resistance (swelling rate) | | | Rinsing properties for engraving residue | |
|---|---|---|---|---|---|---|---|---|---|---|
| | Resin | Mass % | Content of constitutional repeating unit having acid group (mass%) | Polymerizable compound | Mass % | Solvent | UV | Aqueous | pH <10 | pH ≥10 |
| Ex. 12 | A1-9 | 75 | 12 | TEGDMA | 14 | 3 | 3 | 4 | 3 | 4 |
| Comp. Ex. 8 | A1-10 | 75 | 17 | TEGDMA | 14 | 1 | 2 | 4 | 3 | 4 |
| Ex. 13 | A1-11 | 75 | 0.05 | HDDA | 14 | 4 | 4 | 4 | 3 | 4 |
| Ex. 14 | A1-12 | 75 | 0.5 | HDDA | 14 | 3 | 3 | 4 | 3 | 4 |
| Ex. 15 | A1-13 | 75 | 5 | HDDA | 14 | 3 | 3 | 4 | 3 | 4 |
| Ex. 16 | A1-14 | 75 | 10 | HDDA | 14 | 3 | 3 | 4 | 3 | 4 |
| Comp. Ex. 9 | A1-15 | 75 | 16 | HDDA | 14 | 2 | 2 | 3 | 3 | 4 |
| Ex. 17 | A1-11 | 75 | 0.05 | TEGDMA | 14 | 4 | 4 | 4 | 3 | 4 |
| Ex. 18 | A1-12 | 75 | 0.5 | TEGDMA | 14 | 3 | 3 | 4 | 3 | 4 |
| Ex. 19 | A1-13 | 75 | 5 | TEGDMA | 14 | 3 | 3 | 4 | 3 | 4 |
| Ex. 20 | A1-14 | 75 | 10 | TEGDMA | 14 | 3 | 3 | 4 | 3 | 4 |
| Comp. Ex. 10 | A1-15 | 75 | 16 | TEGDMA | 14 | 2 | 2 | 3 | 3 | 4 |
| Ex.21 | A1-16 | 75 | 0.05 | HDDA | 14 | 4 | 4 | 4 | 3 | 3 |
| Ex. 22 | A1-17 | 75 | 0.5 | HDDA | 14 | 4 | 4 | 4 | 3 | 3 |
| Ex. 23 | A1-18 | 75 | 5 | HDDA | 14 | 3 | 4 | 4 | 3 | 4 |
| Ex. 24 | A1-19 | 75 | 10 | HDDA | 14 | 3 | 3 | 4 | 3 | 4 |
| Comp. Ex.11 | A1-20 | 75 | 16 | HDDA | 14 | 2 | 2 | 4 | 4 | 4 |

(Table 2)

| | Component A | | | Component B | | Ink resistance (swelling rate) | | | Rinsing properties for engraving residue | |
|---|---|---|---|---|---|---|---|---|---|---|
| | Resin | Mass % | Content of constitutional repeating unit having acid group (mass%) | Polymerizable compound | Mass % | Solvent | UV | Aqueous | pH <10 | pH ≥10 |
| Ex.25 | A1-16 | 75 | 0.05 | TEGDMA | 14 | 4 | 4 | 4 | 3 | 3 |
| Ex.26 | A1-17 | 75 | 0.5 | TEGDMA | 14 | 4 | 4 | 4 | 3 | 3 |
| Ex.27 | A1-18 | 75 | 5 | TEGDMA | 14 | 3 | 4 | 4 | 3 | 4 |
| Ex. 28 | A1-19 | 75 | 10 | TEGDMA | 14 | 3 | 3 | 4 | 4 | 4 |
| Comp. Ex. 12 | A1-20 | 75 | 16 | TEGDMA | 14 | 1 | 2 | 4 | 4 | 4 |
| Ex.29 | A1-21 | 75 | 0.05 | HDDA | 14 | 4 | 4 | 4 | 3 | 3 |
| Ex. 30 | A1-22 | 75 | 0.5 | HDDA | 14 | 4 | 4 | 4 | 3 | 4 |
| Ex. 31 | A1-23 | 75 | 5 | HDDA | 14 | 4 | 4 | 4 | 3 | 4 |
| Ex. 32 | A1-24 | 75 | 10 | HDDA | 14 | 3 | 3 | 4 | 3 | 4 |
| Comp. Ex. 13 | A1-25 | 75 | 16 | HDDA | 14 | 2 | 2 | 4 | 4 | 4 |
| Ex. 33 | A1-21 | 75 | 0.05 | TEGDMA | 14 | 4 | 4 | 4 | 3 | 3 |
| Ex. 34 | A1-22 | 75 | 0.5 | TEGDMA | 14 | 4 | 4 | 4 | 3 | 4 |
| Ex. 35 | A1-23 | 75 | 5 | TEGDMA | 14 | 4 | 4 | 4 | 3 | 4 |
| Ex. 36 | A1-24 | 75 | 10 | TEGDMA | 14 | 3 | 3 | 4 | 4 | 4 |
| Comp. Ex. 14 | A1-25 | 75 | 16 | TEGDMA | 14 | 2 | 2 | 4 | 4 | 4 |
| Comp. Ex. 15 | A1-26 | 75 | 0 | HDDA | 14 | 4 | 4 | 4 | 1 | 1 |
| Ex. 37 | A1-27 | 75 | 0.3 | HDDA | 14 | 4 | 3 | 4 | 3 | 4 |
| Ex. 38 | A1-28 | 75 | 4 | HDDA | 14 | 4 | 4 | 4 | 3 | 4 |
| Ex. 39 | A1-29 | 75 | 11 | HDDA | 14 | 4 | 4 | 4 | 3 | 4 |

(continued)

| | Component A | | | Component B | | Ink resistance (swelling rate) | | | Rinsing properties for engraving residue | |
|---|---|---|---|---|---|---|---|---|---|---|
| | Resin | Mass % | Content of constitutional repeating unit having acid group (mass%) | Polymerizable compound | Mass % | Solvent | UV | Aqueous | pH <10 | pH ≥10 |
| Comp. Ex. 16 | A1-30 | 75 | 16 | HDDA | 14 | 2 | 2 | 4 | 4 | 4 |
| Comp. Ex. 17 | A1-26 | 75 | 0 | TEGDMA | 14 | 4 | 4 | 4 | 1 | 1 |
| Ex. 40 | A1-27 | 75 | 0.3 | TEGDMA | 14 | 4 | 3 | 4 | 3 | 4 |
| Ex. 41 | A1-28 | 75 | 4 | TEGDMA | 14 | 4 | 4 | 4 | 3 | 4 |
| Ex. 42 | A1-29 | 75 | 11 | TEGDMA | 14 | 4 | 4 | 4 | 4 | 4 |
| Comp. Ex. 18 | A1-30 | 75 | 16 | TEGDMA | 14 | 2 | 2 | 4 | 4 | 4 |
| Comp. Ex. 19 | A1-31 | 75 | 0 | HDDA | 14 | 4 | 4 | 4 | 1 | 2 |
| Ex. 43 | A1-32 | 75 | 0.05 | HDDA | 14 | 4 | 4 | 4 | 3 | 3 |
| Ex. 44 | A1-33 | 75 | 0.5 | HDDA | 14 | 4 | 4 | 4 | 3 | 4 |
| Ex. 45 | A1-34 | 75 | 5 | HDDA | 14 | 4 | 4 | 4 | 3 | 4 |
| Ex. 46 | A1-35 | 75 | 10 | HDDA | 14 | 3 | 3 | 4 | 3 | 4 |
| Comp. Ex. 20 | A1-36 | 75 | 16 | HDDA | 14 | 2 | 2 | 4 | 4 | 4 |
| Comp. Ex. 21 | A1-31 | 75 | 0 | TEGDMA | 14 | 4 | 4 | 4 | 1 | 2 |
| Ex. 47 | A1-32 | 75 | 0.05 | TEGDMA | 14 | 4 | 4 | 4 | 3 | 3 |
| Ex. 48 | A1-33 | 75 | 0.5 | TEGDMA | 14 | 4 | 4 | 4 | 3 | 4 |
| Ex. 49 | A1-34 | 75 | 5 | TEGDMA | 14 | 4 | 4 | 4 | 3 | 4 |
| Ex. 50 | A1-35 | 75 | 10 | TEGDMA | 14 | 3 | 3 | 4 | 4 | 4 |
| Comp. Ex. 22 | A1-36 | 75 | 16 | TEGDMA | 14 | 2 | 2 | 4 | 4 | 4 |

(Table 3)

| | Component A | | | Component B | | Ink resistance (swelling rate) | | | Rinsing properties for engraving residue | |
|---|---|---|---|---|---|---|---|---|---|---|
| | Resin | Mass % | Content of constitutional repeating unit having acid group (mass%) | Polymerizable compound | Mass % | Solvent | UV | Aqueous | pH <10 | pH ≥10 |
| Ex. 51 | A1-37 | 75 | 0.05 | HDDA | 14 | 4 | 4 | 4 | 3 | 3 |
| Ex. 52 | A1-38 | 75 | 0.5 | HDDA | 14 | 4 | 4 | 4 | 3 | 4 |
| Ex. 53 | A1-39 | 75 | 5 | HDDA | 14 | 4 | 4 | 4 | 3 | 4 |
| Ex. 54 | A1-40 | 75 | 10 | HDDA | 14 | 3 | 3 | 4 | 3 | 4 |
| Comp. Ex. 23 | A1-41 | 75 | 16 | HDDA | 14 | 2 | 2 | 4 | 4 | 4 |
| Ex. 55 | A1-37 | 75 | 0.05 | TEGDMA | 14 | 4 | 4 | 4 | 3 | 3 |
| Ex. 56 | A1-38 | 75 | 0.5 | TEGDMA | 14 | 4 | 4 | 4 | 3 | 4 |
| Ex. 57 | A1-39 | 75 | 5 | TEGDMA | 14 | 3 | 3 | 4 | 3 | 4 |
| Ex. 58 | A1-40 | 75 | 10 | TEGDMA | 14 | 3 | 3 | 4 | 4 | 4 |
| Comp. Ex. 24 | A1-41 | 75 | 16 | TEGDMA | 14 | 2 | 2 | 4 | 4 | 4 |
| Comp. Ex. 25 | A1-1 | 75 | 0 | - | - | 1 | 1 | 2 | 1 | 1 |
| Comp. Ex. 26 | A1-2 | 75 | 0.7 | - | - | 1 | 1 | 2 | 3 | 4 |
| Comp. Ex. 27 | A1-3 | 75 | 3 | - | - | 1 | 1 | 2 | 3 | 4 |
| Comp. Ex. 28 | A1-4 | 75 | 11 | - | - | 1 | 1 | 2 | 4 | 4 |
| Comp. Ex. 29 | A1-5 | 75 | 16 | - | - | 1 | 1 | 2 | 4 | 4 |
| Comp. Ex. 30 | A1-37 | 75 | 0.05 | - | - | 1 | 1 | 2 | 3 | 3 |
| Comp. Ex. 31 | A1-38 | 75 | 0.5 | - | - | 1 | 1 | 2 | 3 | 4 |

(continued)

| | Component A | | | Component B | | Ink resistance (swelling rate) | | | Rinsing properties for engraving residue | |
|---|---|---|---|---|---|---|---|---|---|---|
| | Resin | Mass % | Content of constitutional repeating unit having acid group (mass%) | Polymerizable compound | Mass % | Sol-v ent | UV | Aqueous | pH <10 | pH ≥10 |
| Comp. Ex. 32 | A1-39 | 75 | 5 | - | - | 1 | 1 | 2 | 3 | 4 |
| Comp. Ex. 33 | A1-40 | 75 | 10 | - | - | 1 | 1 | 2 | 3 | 4 |
| Comp. Ex.34 | A1-41 | 75 | 16 | - | - | 1 | 1 | 2 | 4 | 4 |

(Table 4)

| | Component A | | | Component B | | Component E | | Ink resistance (swelling rate) | | | Rinsing properties for engraving residue | | Time-related printing durability |
|---|---|---|---|---|---|---|---|---|---|---|---|---|---|
| | Resin | Mass % | Content of constitutional repeating unit having acid group (mass%) | Polymerizable compound | Mass % | compound | Mass % | Solvent | UV | Aqueous | pH <10 | pH ≥10 | |
| Ex. 59 | A1-4 | 75 | 11 | HDDA | 14 | KBM-802 | 0 | 3 | 4 | 4 | 4 | 4 | 2 |
| Ex. 60 | A1-4 | 70 | 11 | HDDA | 14 | KBM-802 | 5 | 3 | 4 | 4 | 4 | 4 | 1 |
| Ex. 61 | A1-13 | 75 | 5 | HDDA | 14 | KBM-802 | 0 | 3 | 3 | 4 | 3 | 4 | 2 |
| Ex. 62 | A1-13 | 70 | 5 | HDDA | 14 | KBM-802 | 5 | 3 | 3 | 4 | 3 | 4 | 1 |
| Ex. 63 | A1-4 | 75 | 11 | HDDA | 14 | KBM-803 | 0 | 3 | 4 | 4 | 4 | 4 | 2 |
| Ex. 64 | A1-4 | 70 | 11 | HDDA | 14 | KBM-803 | 5 | 3 | 4 | 4 | 4 | 4 | 1 |
| Ex. 65 | A1-13 | 75 | 5 | HDDA | 14 | KBM-803 | 0 | 3 | 3 | 4 | 3 | 4 | 2 |
| Ex. 66 | A1-13 | 70 | 5 | HDDA | 14 | KBM-803 | 5 | 3 | 3 | 4 | 3 | 4 | 1 |
| Ex. 67 | A1-4 | 75 | 11 | HDDA | 14 | KBE-8 03 | 0 | 3 | 4 | 4 | 3 | 3 | 2 |
| Ex. 68 | A1-4 | 70 | 11 | HDDA | 14 | KBE-8 03 | 5 | 3 | 4 | 4 | 3 | 3 | 1 |
| Ex. 69 | A1-13 | 75 | 5 | HDDA | 14 | KBE-8 03 | 0 | 3 | 3 | 4 | 3 | 3 | 2 |
| Ex. 70 | A1-13 | 70 | 5 | HDDA | 14 | KBE-8 03 | 5 | 3 | 4 | 4 | 3 | 3 | 1 |

(continued)

| | Component A | | | Component B | | Component E | | Ink resistance (swelling rate) | | | Rinsing properties for engraving residue | | Time-related printing durability |
|---|---|---|---|---|---|---|---|---|---|---|---|---|---|
| | Resin | Mass % | Content of constitutional repeating unit having acid group (mass%) | Polymerizable compound | Mass % | compound | Mass % | Solvent | UV | Aqueous | pH <10 | pH ≥10 | |
| Ex. 71 | A1-4 | 75 | 11 | HDDA | 14 | KBM-846 | 0 | 3 | 4 | 4 | 4 | 4 | 2 |
| Ex. 72 | A1-4 | 70 | 11 | HDDA | 14 | KBM-846 | 5 | 3 | 4 | 4 | 4 | 4 | 1 |
| Ex. 73 | A1-13 | 75 | 5 | HDDA | 14 | KBM-846 | 0 | 3 | 3 | 4 | 3 | 4 | 2 |
| Ex. 74 | A1-13 | 70 | 5 | HDDA | 14 | KBM-846 | 5 | 3 | 3 | 4 | 3 | 4 | 1 |

Details of Component B and Component E shown in Table 1 to Table 4 are as follows.
HDDA: 1,6-hexanediol diacrylate (NK Ester A-HD-N, manufactured by SHIN-NAKAMURA CHEMICAL CO., LTD.)
TEGDMA: triethylene glycol dimethacrylate (NK Ester 3G, manufactured by SHIN-NAKAMURA CHEMICAL CO., LTD.)
KBM-802: 3-mercaptopropyl methyl dimethoxysilane (manufactured by Shin-Etsu Chemical Co., Ltd.)
KBM-803: 3-mercaptopropyl trimethoxysilane (manufactured by Shin-Etsu Chemical Co., Ltd.)
KBE-803: 3-mercaptopropyl triethoxysilane (manufactured by Shin-Etsu Chemical Co., Ltd.)
KBE-846: bis(triethoxysilylpropyl)tetrasulfide (manufactured by Shin-Etsu Chemical Co., Ltd.)

## Claims

**1.** A resin composition for laser engraving comprising:

(Component A) a resin that is a plastomer at 20°C;
(Component B) a polymerizable compound; and
(Component C) a polymerization initiator,
wherein Component A has a constitutional repeating unit having an acid group, and
the content of the constitutional repeating unit having an acid group is 0.01 to 15 mass% relative to a total mass of Component A.

**2.** The resin composition for laser engraving according to Claim 1, wherein Component A has a polymer chain selected from a group consisting of a polyurethane chain, a conjugated diene-based polymer chain, and a polysiloxane chain.

**3.** The resin composition for laser engraving according to Claim 1 or 2, wherein Component A has an ethylenically unsaturated group.

**4.** The resin composition for laser engraving according to any one of Claims 1 to 3, wherein the acid group is a carboxyl group and/or an acid anhydride group.

**5.** The resin composition for laser engraving according to any one of Claims 1 to 4, wherein the acid group is a carboxyl group.

**6.** The resin composition for laser engraving according to any one of Claims 1 to 5, wherein the resin composition further comprises (Component D) a photothermal conversion agent.

**7.** The resin composition for laser engraving according to any one of Claims 1 to 6, wherein Component A has a (meth)acryloyl group.

**8.** A flexographic printing plate precursor having a relief-forming layer formed of the resin composition for laser engraving according to any one of Claims 1 to 7 on a support.

**9.** A flexographic printing plate precursor having a crosslinked relief-forming layer obtained by crosslinking a relief-forming layer formed of the resin composition for laser engraving according to any one of Claims 1 to 7 by heat and/or light.

**10.** The flexographic printing plate precursor for laser engraving according to Claim 9, wherein the crosslinking is performed by using heat.

**11.** A process for producing a flexographic printing plate precursor for laser engraving, comprising steps of:

forming a relief-forming layer formed of the resin composition for laser engraving according to any one of Claims 1 to 7; and
crosslinking the relief-forming layer by heat and/or light to obtain a flexographic printing plate precursor having a crosslinked relief-forming layer.

**12.** The process for producing a flexographic printing plate precursor for laser engraving according to Claim 11, wherein in the step of crosslinking, crosslinking is performed by using heat.

**13.** A process for making a flexographic printing plate, comprising a step of engraving the flexographic printing plate precursor for laser engraving according to Claim 9 or 10 or the flexographic printing plate precursor for laser engraving obtained by the production process according to Claim 11 or 12 by using laser so as to form a relief layer.

**14.** The process for making a flexographic printing plate according to Claim 13, further comprising, after the step of engraving, a step of rinsing the surface of the relief layer with an aqueous rinsing liquid.

**15.** The process for making a flexographic printing plate according to Claim 14, wherein pH of the aqueous rinsing liquid is equal to or more than 10.

**16.** A flexographic printing plate produced by the process for making a flexographic printing plate according to any one of Claims 13 to 15.

Europäisches Patentamt
European Patent Office
Office européen des brevets

# EUROPEAN SEARCH REPORT

Application Number
EP 14 18 1755

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 424 210 A1 (ASAHI KASEI CHEMICALS CORP [JP]) 2 June 2004 (2004-06-02)<br>* abstract; claims *<br>* paragraph [0028] - paragraph [0030] *<br>* paragraph [0108] *<br>* Reference examples 1-9; paragraph [0098] - paragraph [0106]; tables 1-2 *<br>----- | 1-16 | INV.<br>B41C1/10<br>G03F7/032<br>G03F7/033<br>G03F7/035 |
| X | EP 2 617 773 A1 (FUJIFILM CORP [JP]) 24 July 2013 (2013-07-24)<br>* abstract; claims *<br>* paragraph [0028] *<br>* paragraph [0060]; claims 4,5 *<br>* paragraph [0080] - paragraph [0106] *<br>* paragraph [0148] - paragraph [0151] *<br>* paragraph [0181] - paragraph [0201]; examples *<br>* page 21; table 1 *<br>----- | 1-16 | |
| A | EP 2 045 660 A1 (DU PONT [US]) 8 April 2009 (2009-04-08)<br>* abstract; claims 1,2,13-15 *<br>* paragraph [0082] - paragraph [0107] *<br>* paragraph [0114] *<br>----- | 1-16 | TECHNICAL FIELDS SEARCHED (IPC)<br>G03F<br>B41C |
| A | EP 2 095 947 A1 (FUJIFILM CORP [JP]) 2 September 2009 (2009-09-02)<br>* abstract; examples *<br>* paragraph [0021] - paragraph [0026] *<br>* paragraph [0067] - paragraph [0077] *<br>* paragraph [0078] - paragraph [0087] *<br>* paragraph [0286] - paragraph [0318] *<br>----- | 1-16 | |

The present search report has been drawn up for all claims

1

| Place of search | Date of completion of the search | Examiner |
|---|---|---|
| Munich | 8 January 2015 | Paisdor, Bernd |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 14 18 1755

This annex lists the patent family members relating to the patent documents cited in the above-mentioned European search report. The members are as contained in the European Patent Office EDP file on
The European Patent Office is in no way liable for these particulars which are merely given for the purpose of information.

08-01-2015

| Patent document cited in search report | Publication date | Patent family member(s) | Publication date |
|---|---|---|---|
| EP 1424210 A1 | 02-06-2004 | AT 395193 T | 15-05-2008 |
| | | CN 1522203 A | 18-08-2004 |
| | | DK 1424210 T3 | 15-09-2008 |
| | | EP 1424210 A1 | 02-06-2004 |
| | | ES 2301676 T3 | 01-07-2008 |
| | | JP 3801592 B2 | 26-07-2006 |
| | | US 2004157162 A1 | 12-08-2004 |
| | | WO 03022594 A1 | 20-03-2003 |
| EP 2617773 A1 | 24-07-2013 | CN 103217867 A | 24-07-2013 |
| | | EP 2617773 A1 | 24-07-2013 |
| | | JP 5537680 B2 | 02-07-2014 |
| | | JP 2013166369 A | 29-08-2013 |
| | | US 2013186292 A1 | 25-07-2013 |
| EP 2045660 A1 | 08-04-2009 | EP 2045660 A1 | 08-04-2009 |
| | | JP 5408938 B2 | 05-02-2014 |
| | | JP 2009145870 A | 02-07-2009 |
| | | US 2009075199 A1 | 19-03-2009 |
| | | US 2013137043 A1 | 30-05-2013 |
| EP 2095947 A1 | 02-09-2009 | EP 2095947 A1 | 02-09-2009 |
| | | JP 5137618 B2 | 06-02-2013 |
| | | JP 2009204962 A | 10-09-2009 |
| | | US 2009220752 A1 | 03-09-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011148299 A
- JP 2005047947 A
- JP 46027926 B
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 2009204962 A
- JP 2008063554 A
- JP 2008233244 A
- JP 2009178869 A
- JP 2009203310 A
- JP 2011245818 A
- JP 2012045801 A
- JP 2009172658 A
- JP 2009214334 A


### Non-patent literature cited in the description


- Polymer Encyclopedia. Asakura Publishing Co., Ltd, 1988
- *Journal of the Adhesion Society of Japan,* 1984, vol. 20 (7), 300-308
- Senryo Binran. 1970
- Color Index (C.I.) Handbook. Latest Pigments Handbook. 1977
- Saisin Ganryo Ouyogijutsu. CMC Publishing, 1986
- Insatsu Inki Gijutsu. CMC Publishing, 1984
- **MOTOICHI INDO.** Synthetic Fragrances-Chemistry and Knowledge of Products. The Chemical Daily Co., Ltd,
- **SHOJI WATANABE.** Introduction to Fragrance Chemistry. BAIFUKAN CO., LTD,
- Encyclopedia of Fragrance. Asakura Publishing Co., Ltd,
- Fragrance Chemistry Guide II. Hirokawa Shoten Ltd,
- Handbook of Adhesives. 1977
- Laser Handbook. Applied Laser Technology. The Institute of Electronics and Communication Engineers